# EUROPEAN PATENT APPLICATION

(11) **EP 4 709 102 A1**
(43) Date of publication of application: **11.03.2026**
(21) Application number: 25810962.8
(22) Date of filing: 15.04.2025
(51) Int. Cl.: H10F 77/14, H10F 71/00

(54) **BACK-CONTACT SOLAR CELL, PHOTOVOLTAIC MODULE AND PHOTOVOLTAIC SYSTEM**

(30) Priority: 26.07.2024 CN 202411017194; 20.08.2024 CN 202411151681; 03.09.2024 CN 202411231591
(71) Applicant: Zhejiang Aiko Solar Energy Technology Co., Ltd., Jinhua, Zhejiang 322000 (CN); Zhuhai Fushan Aiko Solar Energy Technology Co., Ltd., Zhuhai, Guangdong 519000 (CN); Shenzhen Aiko Digital Energy Technology Co., Ltd., Shenzhen, Guangdong 518000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Chuzhou Aiko Solar Technology Co., Ltd., Chuzhou, Anhui 239514 (CN); Shandong Aiko Solar Technology Co., Ltd, Jinan, Shandong 250000 (CN)
(72) Inventor: WANG, Yongqian, Jinhua, Zhejiang 322000 (CN); CHEN, Hui, Jinhua, Zhejiang 322000 (CN); YANG, Xinqiang, Jinhua, Zhejiang 322000 (CN); CHEN, Gang, Jinhua, Zhejiang 322000 (CN); SONG, Banghao, Jinhua, Zhejiang 322000 (CN); DING, Sen, Jinhua, Zhejiang 322000 (CN); WU, Yinqi, Jinhua, Zhejiang 322000 (CN); MA, Binghao, Jinhua, Zhejiang 322000 (CN); TANG, Wenwei, Jinhua, Zhejiang 322000 (CN)
(74) Representative: EP&C
(86) International application number: PCT/CN2025/089127
(87) International publication number: WO 2026/020893

(57) **Abstract**

The present disclosure provides a back contact solar cell, including P-type doped regions, N-type doped regions, and isolation regions, wherein the P-type doped region and the N-type doped region are alternately disposed on a non-illuminated side of an N-type silicon substrate, and the isolation region located between the P-type doped region and the N-type doped region, wherein the side of the P-type doped region close to the isolation region is provided with n1 recessed structures, the side of the N-type doped region close to the isolation region is provided with n2 recessed structures, and n1>n2.

## Description

### Cross-Reference to Related Application

The present disclosure claims the priority of Chinese Patent Application 202411017194.6, filed in the China National Intellectual Property Administration on July 26, 2024, and entitled "Back Contact Solar Cell, Photovoltaic Module and Photovoltaic System", the priority of Chinese Patent Application 202411151681.1, filed in the China National Intellectual Property Administration on August 20, 2024, and entitled "Back Contact Cell, Photovoltaic Module and Photovoltaic System", and the priority of Chinese Patent Application 202411231591.3, filed in the China National Intellectual Property Administration on September 3, 2024, and entitled "Back Contact Cell, Photovoltaic Module and Photovoltaic System", the entire contents of which are herein incorporated by reference.

### Technical Field

The present disclosure relates to the technical field of solar cell, and particularly relates to a back contact solar cell, a photovoltaic module, and a photovoltaic system.

### Background

An interdigitated back contact (IBC) cell is an efficient solar cell technology, positive and negative metal electrodes of the IBC cell are arranged on a non-illuminated side of the cell in an interdigitated pattern, so that a front surface of the cell is not shielded by any metal grid in this design, thereby maximizing an illumination area, reducing optical losses, and improving short-circuit current and the overall power conversion efficiency. In order to avoid direct contact of carriers in an N-type doped region and a P-type doped region, the carriers cannot be effectively collected, an isolation region needs to be disposed at the junction of the P-type doped region and the N-type doped region, as the size of the cell is decreased, the N-type doped region and the P-type doped region are disposed more tightly, and correspondingly, the size of the isolation region is decreased accordingly. However, if the isolation region is too narrow, sufficient insulation protection cannot be provided, which increases the possibility of a short circuit, resulting in a reduction in the power conversion efficiency of the back contact cell. Moreover, in a conventional interdigitated back contact cell, a surface passivation layer is usually formed on one side of the non-illuminated side of the interdigitated back contact cell to reduce the recombination rate of the carriers on one side of the non-illuminated side of the interdigitated back contact cell and to improve the power conversion efficiency of the interdigitated back contact cell. However, the passivation effect of the surface passivation layer in the existing interdigitated back contact cell for one side of the non-illuminated side is poor, which is not conducive to improving the power conversion efficiency of the interdigitated back contact cell.

### Summary

The primary objective of the present disclosure is to provide a back contact solar cell, a photovoltaic module, and a photovoltaic system, which can enhance isolation performance between differently doped regions on the non-illuminated side of back contact solar cell, improve passivation effectiveness, and increase the power conversion efficiency of solar power.

To achieve the above objectives, according to one aspect of the present disclosure, there is provided a back contact solar cell, including first regions, second regions and isolation regions, which are disposed on a non-illuminated side of a silicon substrate, wherein the first region and the second region are alternately disposed, the isolation region is located between the first region and the second region, the first region includes a first doped conductive layer, the second region includes a second doped conductive layer, and the first doped conductive layer and the second doped conductive layer have opposite doping types; and the side of the first region close to the isolation region is provided with a recessed structure, when the silicon substrate is an N-type silicon substrate, the first region is a P-type doped region, the second region is an N-type doped region, the side of the P-type doped region close to the isolation region is provided with n1 recessed structures, the side of the N-type doped region close to the isolation region is provided with n2 recessed structures, and n1>n2.

In some embodiments, the side of the first region close to the isolation region is provided with discontinuous recessed structures; and/or the side of the second region close to the isolation region is provided with recessed structures.

In some embodiments, the side of the second region close to the isolation region is provided with discontinuous recessed structures.

In some embodiments, the recessed structure includes a first unit region and a first recessed structure, the first unit region is disposed around the first recessed structure, and the first recessed structure includes a pit and a protrusion disposed in the pit; or the first region includes an extension portion extending and protruding to the upper side of the isolation region, the recessed structure includes a second unit region and a second recessed structure, the second unit region is disposed around the second recessed structure, the extension portion is provided with the second recessed structure, and the second recessed structure is a blind hole or a punch hole.

In some embodiments, the height of the protrusion is less than or equal to the depth of the pit; or the shape of the protrusion includes a pyramid shape and/or a frustum shape; or the silicon substrate has an illuminated side disposed opposite to the non-illuminated side, the protrusion includes the silicon substrate and a passivation layer in a direction in which the illuminated side faces the non-illuminated side, and a sidewall of the pit includes the passivation layer.

In some embodiments, the width of the bottom of the protrusion is 0.1 µm to 1.5 µm, and the height of the protrusion is 0.01 µm to 10 µm; or the width of the opening of the pit is 0.1 µm to 2 µm, and the depth of the pit is 0.01 µm to 10 µm.

In some embodiments, the passivation layer of the back contact solar cell surrounds the extension portion, and the second recessed structure penetrates through the extension portion and the passivation layer; or the width of the second recessed structure is 0.1 µm to 1.5 µm.

In some embodiments, a plurality of recessed structures form an isolation transition region, and the width of the isolation transition region is 5 µm to 30 µm.

In some embodiments, the width of the isolation transition region is 10 µm to 15 µm.

In some embodiments, a tunneling layer of the back contact solar cell includes a first tunneling layer, the first tunneling layer is disposed between the first conductive doped layer and the silicon substrate of the first region, and the first doped conductive layer, the first tunneling layer and an edge of the silicon substrate in the first region all extend towards the center of the opening of the isolation region to form the extension portion, or only the first doped conductive layer extends towards the center of the opening of the isolation region to form the extension portion; and/or, the tunneling layer of the back contact solar cell further includes a second tunneling layer, the second tunneling layer is disposed between the second doped conductive layer and the silicon substrate of the second region; or the passivation layer of the back contact solar cell covers the first doped conductive layer, the second doped conductive layer and the isolation region, the back contact solar cell further includes a first electrode and a second electrode, the first electrode penetrates through the passivation layer to be connected with the first doped conductive layer, and the second electrode penetrates through the passivation layer to be connected with the second doped conductive layer.

In some embodiments, the diameter of the second recessed structure is 1.5 µm to 5 µm; or the length of the extension portion is 0.1 µm to 40 µm.

In some embodiments, the side of the first region close to the isolation region includes a first target region, the length of the first target region in an extension direction of the isolation region is greater than 50 µm, and the first target region does not include the recessed structure; and the side of the second region close to the isolation region includes a second target region, the length of the second target region in the extension direction of the isolation region is greater than 50 µm, and the second target region does not include the recessed structure.

According to another aspect of the present disclosure, there is provided a back contact solar cell, including: a silicon substrate, wherein the silicon substrate has an illuminated side and a non-illuminated side opposite to each other, the non-illuminated side includes first regions and second regions, which are alternately arranged in a first direction, the first regions and the second regions all extend in a third direction, and the third direction intersects with the first direction; several first doped conductive layers, wherein the first doped conductive layers are disposed on the first regions and cover at least part of the first regions, each first region is provided with the first doped conductive layer, and first recessed structures are formed on at least part of the first doped conductive layers; and several second doped conductive layers, wherein the second doped conductive layers are disposed on the second regions and cover at least part of the second regions, each second region is provided with the second doped conductive layer, at least part of the second doped conductive layers are provided with leakage-prone contacts extending to the first doped conductive layers, and a part of the leakage-prone contacts extend into the first recessed structures, and the leakage-prone contacts are in leakage contact with the first doped conductive layers at least in the first recessed structures.

**In** some embodiments, the leakage-prone contact includes a first portion located in the first recessed structure, and a second portion stacked on the surface of the first doped conductive layer facing away from the silicon substrate, the first portion is in leakage contact with the first doped conductive layer, an dielectric insulating layer is disposed between the second portion and the first doped conductive layer, or the second portion is in leakage contact with the surface of the first doped conductive layer facing away from the silicon substrate; or in the first direction, the leakage-prone contact extends along a side surface of the first doped conductive layer to the surface of the first doped conductive layer facing away from the silicon substrate and into the first recessed structure, and the leakage-prone contact also forms a leakage contact with the first doped conductive layer at the side surface of the first doped conductive layer; or in the first direction, there is a first predetermined distance between the first recessed structure and the side surface of the first doped conductive layer, and the size of the first predetermined distance is 10 µm to 200 µm; or in the first direction, the length of the first recessed structure is 10 µm to 80 µm, and/or in the third direction, the length of the first recessed structure is less than 10 µm to 500 µm.

**In** some embodiments, the ratio of the length of the first recessed structure in the third direction to the length of the first recessed structure in the first direction is greater than or equal to 2.

**In** some embodiments, the first doped conductive layer has a first side surface and a second side surface opposite to each other in the first direction, the first recessed structure does not penetrate through the first side surface and the second side surface, and both sides of the first recessed structure are provided with the first doped conductive layers in the first direction; or the first doped conductive layer has the first side surface and the second side surface opposite to each other in the first direction, and the first recessed structure penetrates through at least one of the first side surface and the second side surface; or the first recessed structure completely penetrates through the first doped conductive layer in a thickness direction of the first doped conductive layer, so that the silicon substrate is exposed at the first recessed structure, and the leakage-prone contact covers the silicon substrate exposed from the first recessed structure, and covers at least part of regions of a sidewall surface of the first recessed structure; or the first recessed structure does not completely penetrate through the first doped conductive layer in the thickness direction of the first doped conductive layer, and the leakage-prone contact covers at least part of regions of a bottom surface of the first recessed structure and at least part of regions of the sidewall surface of the first recessed structure; or the first recessed structure completely penetrates through the first doped conductive layer in the thickness direction of the first doped conductive layer and forms a trench in the silicon substrate, and a recess depth of the trench in the thickness direction of the silicon substrate is 1 µm to 6 µm; or the first recessed structure completely penetrates through the first doped conductive layer in the thickness direction of the first doped conductive layer and forms a trench in the silicon substrate, the first doped conductive layers located on both sides of the trench are provided with second protruding portions extending to the upper side of the trench, and the leakage-prone contact surrounds at least one of the second protruding portions and extends into the first recessed structure; or the first recessed structure completely penetrates through the first doped conductive layer in the thickness direction of the first doped conductive layer and forms a trench in the silicon substrate, and there is a second predetermined distance between the first doped conductive layers located on the both sides of the trench and an edge of the trench in the first direction.

**In** some embodiments, an internal expansion layer is formed in a portion of the silicon substrate corresponding to the first region, and the polarity of the internal expansion layer is the same as the doping type of the first doped conductive layer; the first recessed structure does not penetrate through the internal expansion layer, and the leakage-prone contact is in leakage contact with the surface of the internal expansion layer facing away from the silicon substrate; or the first recessed structure penetrates through the internal expansion layer, and the leakage-prone contact is in leakage contact with a side surface of the internal expansion layer that is exposed at the first recessed structure.

In some embodiments, the second region is a groove formed in the silicon substrate, the first doped conductive layer is provided with a first protruding portion extending to the upper side of the groove, and the leakage-prone contact extends along a sidewall surface of the groove to surround the first protruding portion and extends onto the first doped conductive layer, and extends into the first recessed structure; or the second region is a groove formed in the silicon substrate, the first doped conductive layer does not completely cover the first region, so that the first region has an exposed region, which is not covered by the first doped conductive layer, between the first doped conductive layer and the groove, and the leakage-prone contact extends to the exposed region and covers the exposed region; or at an edge of the side of the first doped conductive layer facing the groove, the first doped conductive layer is formed with a step structure, the leakage-prone contact covers the step structure, and the leakage-prone contact is in leakage contact with the first doped conductive layer at the step structure.

In some embodiments, a dielectric layer is disposed on a region in the first recessed structure that is covered by the leakage-prone contact, the leakage-prone contact covers the dielectric layer, and the leakage-prone contact is in leakage contact with the first doped conductive layer in the first recessed structure by means of the dielectric layer.

In some embodiments, the size of the second predetermined distance is 0.3 µm to 50 µm.

In some embodiments, the first recessed structure does not completely penetrate through the first doped conductive layer in the thickness direction of the first doped conductive layer, and the recess depth of the first recessed structure is 20 nm to 200 nm; or on a single first doped conductive layer, there are a plurality of first recessed structures, and the plurality of first recessed structures are arranged at intervals in the third direction.

In some embodiments, in the third direction, the distance between two adjacent first recessed structures is 1 cm to 10 cm; or the plurality of first recessed structures are arranged in at least two columns in the third direction.

In some embodiments, in the back contact solar cell, the distribution density of the first recessed structures is 0.01 piece/cm2 to 1.5 pieces/cm2; or in a single first recessed structure, a leakage contact area between the leakage-prone contact and the first doped conductive layer is 1.2 µm2 to 1500 µm2; or in the back contact solar cell, the ratio of the sum of leakage contact areas of all leakage-prone contacts and the first doped conductive layers to the area of the back surface of the back contact solar cell is 4.5*10-8 to 1.5*10-5.

In some embodiments, regions in the first doped conductive layer and the second doped conductive layer that are not covered by the leakage-prone contacts are leakage-free regions, and regions in the first doped conductive layer and the second doped conductive layer other than the leakage-free regions are leakage-prone regions; and within the same unit length, the number of the first recessed structures in the leakage-free regions is greater than the number of the first recessed structures in the leakage-prone regions.

According to a further aspect of the present disclosure, there is provided a photovoltaic module, including any of the back contact solar cell as described above.

According to yet a further aspect of the present disclosure, there is provided a photovoltaic system, including the photovoltaic module as described above.

The implementation of the present disclosure has the following beneficial effects:
1. In the present disclosure, the side of the first region on the non-illuminated side of the back contact cell that is close to the isolation region is provided with the recessed structure, so as to improve the isolation effect of the first region and the second region by the isolation region. In addition, the recessed structure increases a contact area between the first region and the subsequently grown passivation layer, thereby improving the passivation effect.
2. In the present disclosure, the side of the second region on the non-illuminated side of the back contact cell that is close to the isolation region is provided with the recessed structure, so as to improve the isolation effect of the first region and the second region by the isolation region. In addition, the recessed structure increases a contact area between the second region and the subsequently grown passivation layer, thereby improving the passivation effect.
3. In the present disclosure, the first recessed structure includes the pit and the protrusion disposed in the pit, and the bottom of the pit is formed on the silicon substrate, so that the isolation effect of the first region and the second region can be improved; and the contact area with the subsequently deposited passivation layer is further increased by disposing the protrusion, so that the overall passivation performance is further improved.
4. In the present disclosure, the edges of the first region and the isolation region are provided with the extension portion extending and protruding to the upper side of the isolation region, so as to form the isolation region with a small opening and a large interior, thereby reducing the exchange of plasma and outside during subsequent deposition of the passivation layer; and the extension portion is provided with the second recessed structure, and the second recessed structure penetrates through the extension portion, thereby improving the isolation passivation performance of the extension portion.

### Brief Description of the Drawings

The drawings, which constitute a part of the present disclosure, are used to provide a further understanding of the present disclosure, and schematic embodiments of the present disclosure and descriptions thereof are used to explain the present disclosure, and do not constitute an improper limitation on the present disclosure. In the drawings:
Fig. 1 is a first schematic structural diagram of a back contact solar cell provided in the present disclosure;
Fig. 2 is a 3D micrograph of a non-illuminated side of a back contact solar cell provided in the present disclosure;
Fig. 3 is a schematic structural diagram of a first recessed structure provided in an embodiment of the present disclosure;
Fig. 4 is a schematic diagram of a size of a first recessed structure provided in an embodiment of the present disclosure;
Fig. 5 is a schematic structural diagram of a second recessed structure provided in an embodiment of the present disclosure;
Fig. 6 is an electron microscope diagram of a recessed structure provided in an embodiment of the present disclosure;
Fig. 7 is an electron microscope diagram of a first recessed structure provided in an embodiment of the present disclosure;
Fig. 8 is a second schematic structural diagram of a back contact solar cell provided in the present disclosure;
Fig. 9 is a schematic structural diagram of one embodiment of a back contact solar cell provided in the present disclosure, in which an extension portion is provided with a second recessed structure;
Fig. 10 is a schematic structural diagram of another embodiment of a back contact solar cell provided in the present disclosure, in which an extension portion has a second recessed structure;
Fig. 11 is a schematic diagram of an enlarged structure of a hole portion in Fig. 10;
Fig. 12 is a schematic structural diagram of one embodiment of a back contact solar cell provided in the present disclosure, in which first regions, first tunneling layers and first doped conductive layers are all provided with extension portions;
Fig. 13 is a schematic diagram of a micro-structure of another embodiment of a back contact solar cell provided in the present disclosure, in which first regions, first tunneling layers and first doped conductive layers are all provided with extension portions;
Fig. 14 is a schematic structural diagram of one embodiment of a back contact solar cell provided in the present disclosure, in which only first doped conductive layers are provided with extension portions;
Fig. 15 is a schematic diagram of a micro-structure of another embodiment of a back contact solar cell provided in the present disclosure, in which only first doped conductive layers are provided with extension portions;
Fig. 16 is a schematic structural diagram of another embodiment of a back contact solar cell provided in the present disclosure, in which only first doped conductive layers are provided with extension portions; and
Fig. 17 is a schematic diagram of a micro-structure of another embodiment of a back contact solar cell provided in the present disclosure, in which only first doped conductive layers are provided with extension portions.
Fig. 18 is a schematic diagram of modules of a photovoltaic system provided in an embodiment of the present disclosure;
Fig. 19 is a schematic diagram of modules of a cell module provided in an embodiment of the present disclosure;
Fig. 20 is a schematic diagram of a plane structure of a back contact solar cell provided in an embodiment of the present disclosure;
Fig. 21 is a schematic sectional view of the back contact solar cell of Fig. 20 along a line IV-IV;
Fig. 22 is another schematic sectional view of a back contact solar cell provided in an embodiment of the present disclosure;
Fig. 23 is another schematic sectional view of a back contact solar cell provided in an embodiment of the present disclosure;
Fig. 24 is a schematic diagram of arrangement and structure of a first recessed structure in a back contact solar cell provided in an embodiment of the present disclosure;
Fig. 25 is a schematic diagram of another plane structure of a back contact solar cell provided in an embodiment of the present disclosure;
Fig. 26 is a schematic diagram of another arrangement and structure of a first recessed structure in a back contact solar cell provided in an embodiment of the present disclosure;
Fig. 27 is yet another schematic sectional view of a back contact solar cell provided in an embodiment of the present disclosure;
Fig. 28 is still another schematic sectional view of a back contact solar cell provided in an embodiment of the present disclosure;
Fig. 29 is still another schematic sectional view of a back contact solar cell provided in an embodiment of the present disclosure;
Fig. 30 is still another schematic sectional view of a back contact solar cell provided in an embodiment of the present disclosure; and
Fig. 31 is still another schematic sectional view of a back contact solar cell provided in an embodiment of the present disclosure.

### Detailed Description of the Embodiments

It should be noted that the following detailed descriptions are exemplary and are intended to provide further description of the present disclosure. Unless otherwise specified, all technical and scientific terms used herein have the same meanings as commonly understood by those ordinary skilled in the art to which the present disclosure belongs.

It should be noted that the terms used herein are for the purpose of describing particular implementations only and are not intended to limit exemplary implementations according to the present disclosure. As used herein, unless the context clearly indicates otherwise, a singular form is intended to include a plural form as well, and it should also be understood that when the terms "contain" and/or "include" are used in the present specification, they indicate the presence of features, steps, operations, devices, components, and/or combinations thereof.

It should be noted that the terms "first" and "second" and the like in the specification, claims and the above drawings of the present disclosure are used for distinguishing similar objects, and are not necessarily used for describing a specific sequence or precedence order. It should be understood that data used in this way can be interchanged under appropriate circumstances, so as to describe the embodiments of the present disclosure . In addition, the terms "include" and "have" and any variations thereof are intended to cover non-exclusive inclusions, for example, processes, methods, systems, products or devices including a series of steps or units are not necessarily limited to those clearly listed steps or units, but can include other steps or units that are not clearly listed or are inherent to these processes, methods, products or devices.

It should be understood that, when an element (e.g., a layer, a film, a region, or a substrate) is described as being "on" another element, the element can be directly on the other element, or there can also be an intervening element. Moreover, in the specification and the claims, when an element is described as being "connected" to another element, the element can be "directly connected" to the other element, or "connected" to the other element by means of a third element.

As introduced in the background art, during the use of a back contact solar cell in the prior art, when a shading object in an external environment obstructs a cell, a hot spot phenomenon occurs on the shading cell, therefore when the temperature is relatively high, a packaging adhesive film of an module is prone to carbonization and even a fire is caused. In order to solve at least one of the following problems in the prior art: poor hot spot resistance, low isolation performance of different doped regions on a non-illuminated side of a back contact solar cell, low power conversion efficiency of the solar cell, low performance of the back contact solar cell, and easy confusion of identification, embodiments of the present disclosure provide a back contact solar cell, a photovoltaic module, and a photovoltaic system. The back contact solar cell includes first regions and second regions, which are disposed on a non-illuminated side of a silicon substrate, wherein the first region and the second region are alternately disposed, the first region includes a first doped conductive layer, the second region includes a second doped conductive layer, and the first doped conductive layer and the second doped conductive layer have opposite doping types.

The technical solutions in the embodiments of the present disclosure will be clearly and completely described below in combination with the drawings in the embodiments of the present disclosure.

In some optional implementations, a back contact solar cell includes first regions and second regions, which are disposed on a non-illuminated side of a silicon substrate, wherein the first region and the second region are alternately disposed, the first region includes a first doped conductive layer, the second region includes a second doped conductive layer, and the first doped conductive layer and the second doped conductive layer have opposite doping types. The back contact solar cell further includes isolation regions, and the isolation region are located between the first region and the second region. The side of the first region close to the isolation region is provided with a recessed structure.

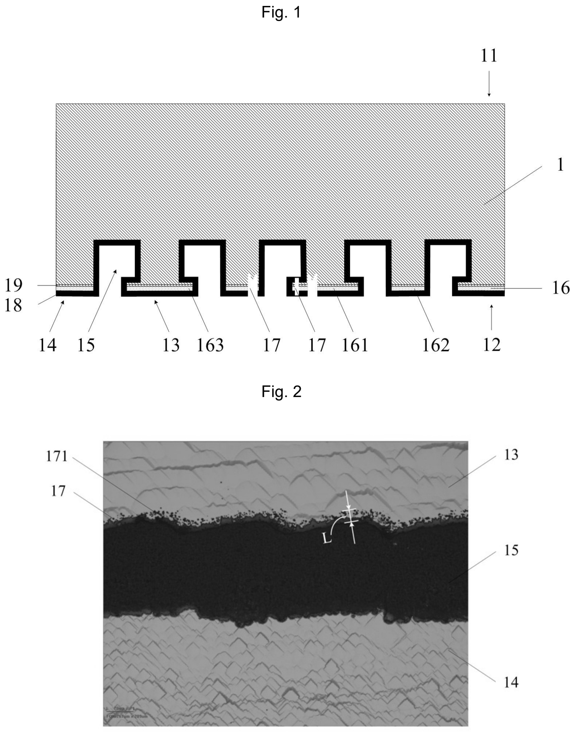

Referring to Fig. 1, the present disclosure provides a back contact solar cell, including first regions 13, second regions 14 and isolation regions 15, which are disposed on a non-illuminated side 12 of a silicon substrate 1, wherein the first regions 13 and the second regions 14 are alternately disposed, the first region 13 includes a first doped conductive layer 161, the second region 14 includes a second doped conductive layer 162, and the first doped conductive layer 161 and the second doped conductive layer 162 have opposite doping types. Specifically, the first doped conductive layer can have an opposite or the same doping type as the silicon substrate, and the first doped conductive layer and the second doped conductive layer have opposite conductivity types, therefore one side of the non-illuminated side of the back contact solar cell has the first regions and the second regions with opposite conductivity types, and the isolation region is disposed between the first region and the second region with the opposite conductivity types, and the first regions and the second regions distributed at intervals can prevent a short circuit caused by the contact of the first regions and the second regions.

The side of the first region 13 close to the isolation region 15 is provided with a recessed structure 17.

Compared with the prior art in which the isolation region is disposed between the first region and the second region, in the present disclosure, the side of the first region close to the isolation region is further provided with the recessed structure, therefore the isolation between the first region and the second region can be further improved by disposing the recessed structure. Due to a decrease in an existing cell structure, the spacing between the first region and the second region with different doping types is also smaller and smaller, and the requirements for the isolation region between the first region and the second region are also higher and higher. By disposing the recessed structure, the isolation effect of the first region and the second region can be increased under the same width of the isolation region. By disposing the recessed structure, the light absorption effect can also be improved, the reflectivity of light can be reduced, and more light generates carriers in the silicon substrate, thereby improving the power conversion efficiency of the cell. In addition, by disposing the recessed structure, a contact area between the first region and a passivation layer that is subsequently deposited on the surface thereof is also increased, so that the surface passivation effect of the first region by the passivation layer can be improved, and the power conversion efficiency of the back contact solar cell is further improved.

In a preferred implementation, as shown in Fig. 2, the side of the first region 13 close to the isolation region 15 is provided with discontinuous recessed structures 17, and several discontinuous recessed structures form an isolation transition region 171. Due to the discontinuous distribution of the recessed structures, the isolation effect of the first region and the second region can be further improved. Specifically, the width L of the isolation transition region 171 can be set to be 5 µm to 30 µm, exemplarily, 6 µm, 8 µm, 10 µm, 15 µm, 20 µm, or 25 µm, but it is not limited thereto. More preferably, the width L of the isolation transition region 171 is 10 µm to 15 µm. By controlling the width range of the isolation transition region 171, no adverse effect is generated on the own performance of the first region 13 and the second region 14 while improving the isolation performance, thereby ensuring the collection and transmission effects of carriers.

Correspondingly, the side of the second region close to the isolation region can also be provided with a recessed structure, and the function of the recessed structure is the same as that of the recessed structure on the side of the first region close to the isolation region. In a preferred implementation, the side of the second region close to the isolation region is provided with discontinuous recessed structures, similarly, several discontinuous recessed structures form an isolation transition region, the width of the isolation transition region is 5 µm to 30 µm, and more preferably, the width of the isolation transition region is 10 µm to 15 µm.

Specifically, as shown in Fig. 1, Fig. 3, Fig. 6 and Fig. 7, the recessed structure 17 includes a first unit region 172 and a first recessed structure 173, the first unit region 172 is disposed around the first recessed structure 173, and the first recessed structure 173 includes a pit 174 and a protrusion 175 disposed in the pit 174. Specifically, the silicon substrate 1 includes an illuminated side 11 and a non-illuminated side 12, which are disposed opposite to each other, in a direction in which the illuminated side 11 faces the non-illuminated side 12, the protrusion 175 includes the silicon substrate 1 and a passivation layer 18, a sidewall of the pit 174 includes the passivation layer 18, the first unit region 172 includes the silicon substrate 1, a tunneling layer 19, a doped conductive layer 16 and the passivation layer 18, and the silicon substrate 1, the tunneling layer 19, the doped conductive layer 16 and the passivation layer 18 are stacked in sequence. It should be noted that, on the first region 13, the doped conductive layer 16 included in the first unit region 172 is the first doped conductive layer 161, and on the second region 14, the doped conductive layer 16 included in the first unit region 172 is the second doped conductive layer 162. By forming the first recessed structure 173 in the first region 13 and/or the second region 14, the bottom of the pit 174 of the first recessed structure 173 is disposed on the silicon substrate 1, so that the isolation effect of the first region 13 and the second region 14 can be improved, the passivation layer 18 covers the upper side of the first recessed structure 173, and by disposing the protrusion 175, a contact area between the passivation layer 18 and the first region 13 and/or the second region 14 is further increased, thus the overall passivation performance is further improved.

By disposing the passivation layer 18, the recombination of surface carriers can be reduced. The passivation layer 18 covers the first region 13, the second region 14 and the isolation region 15, and the passivation layer 18 can passivate the side of the first doped conductive layer 161 facing away from the silicon substrate 1 and the side of the second doped conductive layer 162 facing away from the silicon substrate 1, so as to reduce the recombination rate of the carriers on the side of the first doped conductive layer 161 facing away from the silicon substrate 1 and the side of the second doped conductive layer 162 facing away from the silicon substrate 1, thereby further improving the power conversion efficiency of the back contact solar cell. The passivation layer 18 can be one or more of an aluminum oxide layer, a silicon nitride layer, a silicon oxide layer and a silicon oxynitride layer, and preferably, the passivation layer 18 includes an aluminum oxide layer and a silicon nitride layer, which are stacked in sequence.

The tunneling layer can be divided into a first tunneling layer and a second tunneling layer; the first tunneling layer is disposed between the silicon substrate in the first region and the first doped conductive layer; and the second tunneling layer is disposed between the silicon substrate in the second region and the second doped conductive layer, and the tunneling layer allows the majority of carriers to tunnel into the doped conductive layers while blocking the minority of carriers to pass through, therefore the majority of carriers are transmitted by the first doped conductive layer and the second doped conductive layer and are collected by corresponding electrodes, thereby reducing the recombination rate of carriers of different conductivity types on the surface of the first region or the surface of the second region, implementing selective collection of excellent carriers, and further improving the power conversion efficiency of the back contact solar cell. The first tunneling layer and the second tunneling layer can be one or more of a silicon oxide layer, a silicon carbide layer, a silicon nitride layer and an aluminum oxide layer, and preferably, the first tunneling layer and the second tunneling layer are silicon oxide layers.

In a preferred implementation, the height of the protrusion is less than or equal to the depth of the pit, more preferably, the height of the protrusion is less than the depth of the pit, so as to facilitate the deposition of the subsequent passivation layer, and specifically, the protrusion can be in a pyramid shape and/or a frustum shape.

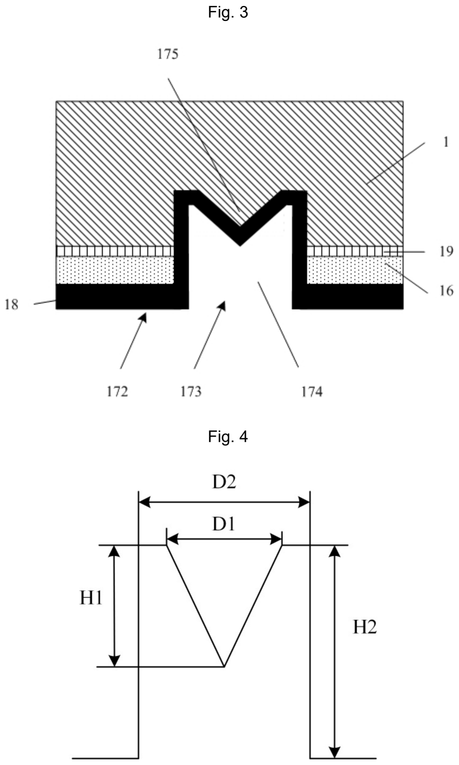

It can be understood that, the size of the protrusion and the size of the pit can also generate a certain impact on the isolation effect and the passivation performance, as shown in Fig. 4, the width D1 of the bottom of the protrusion is 0.1 µm to 1.5 µm, the height H1 of the protrusion is 0.01 µm to 10 µm, if H1 is less than 0.01 µm, it is easy to cause a short circuit, thereby reducing the yield; and if H1 is greater than 10 µm, the coverage of the subsequent passivation layer is affected to reduce the passivation effect. The width D2 at the opening of the pit is 0.1 µm to 2 µm, the depth H2 of the pit is 0.01 µm to 10 µm, and if D2 is less than 0.1 µm, the passivation effect is affected; and if D2 is greater than 10 µm, a copper residue impact is generated, resulting in leakage. The passivation effect is affected by excessively large or small H2, if H2 is less than 0.01 µm, hydrogen passivation of the subsequently deposited passivation layer on the silicon substrate is weakened, thereby reducing the yield; and if H2 is greater than 10 µm, the recombination of the carriers on the surface of the silicon substrate is increased. By limiting the size of the protrusion and the size of the pit, the passivation performance and the isolation performance of the cell can be improved without generating adverse effects on the collection and transmission of the carriers, and moreover, by controlling the size of the protrusion and the size of the pit within the scopes of the present disclosure, subsequent formation of a back-surface passivation layer is facilitated, and the passivation layer can be completely filled into the first recessed structure, thereby improving the film forming quality of the passivation layer.

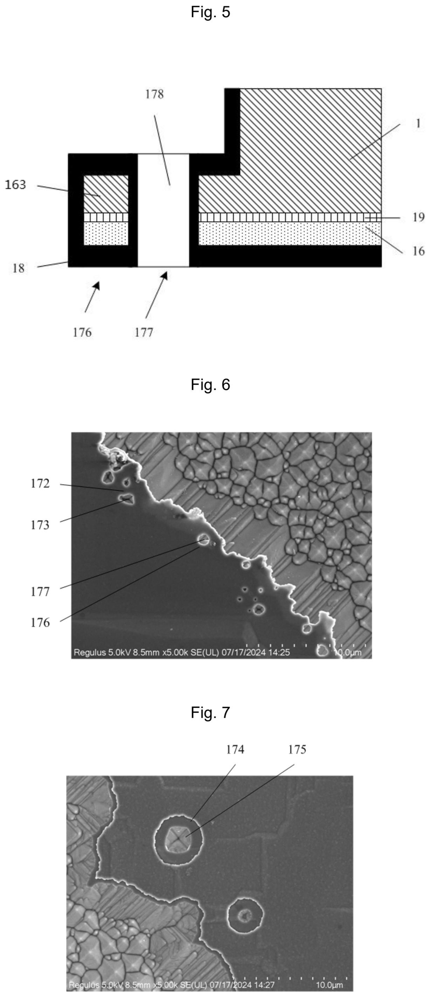

As shown in Fig. 1, Fig. 5 and Fig. 6, the first region 13 includes an extension portion 163 extending and protruding to the upper side of the isolation region 15; the recessed structure 17 includes a second unit region 176 and a second recessed structure 177, and the second unit region 176 is disposed around the second recessed structure 177, wherein the extension portion 163 is provided with the second recessed structure 177, and the second recessed structure 177 can be a blind hole or a punch hole. Exemplarily, as shown in Fig. 5 and Fig. 6, the second recessed structure 177 penetrates through the extension portion 163 to form a pore 178, that is, in this embodiment, the second recessed structure 177 is a punch hole (the pore 178).

In a preferred implementation, as shown in Fig. 5, the back contact solar cell includes the passivation layer 18 surrounding the extension portion 163, and the second recessed structure 177 penetrates through the extension portion 163 and the passivation layer 18 to form the pore 178. The passivation layer 18 surrounds the extension portion 163 to further ensure the passivation performance. In one implementation, the width D3 of the pore 178 is 0.1 µm to 1.5 µm, exemplarily, 0.2 µm, 0.5 µm, 0.8 µm, 1 µm, 1.1 µm, or 1.4 µm, but it is not limited thereto.

In addition to the above structures, the back contact solar cell further includes a front-surface passivation layer, a first electrode and a second electrode. The front-surface passivation layer is stacked on the front surface of the silicon substrate, and there is no metal electrode shading effect on the front surface; and the first electrode penetrates through the passivation layer to form a contact with the first doped conductive layer, the second electrode penetrates through the passivation layer to form a contact with the second doped conductive layer, and the material of the first electrode and the material of the second electrode can be one or more of silver, aluminum, copper and nickel.

In a preferred implementation, the number of recessed structures on the side of the doped region having a different doping type from the silicon substrate is greater than or equal to the number of recessed structures on the side of the doped region having the same doping type as the silicon substrate, thereby improving the liquid flow guidance effect of subsequent procedures and facilitating the cleaning of impurities such as metals, and thus improving the surface quality of the recessed structures; and in addition, the greater number of recessed structures of an emitter better facilitate the collection of current. It can be understood that, when the silicon substrate is a P-type silicon substrate, the first doped region is an N-type doped region, the second doped region is a P-type doped region, the side of the P-type doped region close to the isolation region is provided with n1 recessed structures, the side of the N-type doped region close to the isolation region is provided with n2 recessed structures, n1≤n2, and preferably, n1<n2. That is, when the silicon substrate is the P-type silicon substrate, the number of the recessed structures on the side of the P-type doped region close to the isolation region is less than or equal to the number of the recessed structures on one side of the N-type doped region. Further, when the silicon substrate is the P-type silicon substrate, n1 can be 0.

Correspondingly, when the silicon substrate is an N-type silicon substrate, the first doped region is a P-type doped region, the second doped region is an N-type doped region, the side of the P-type doped region close to the isolation region is provided with n1 recessed structures, the side of the N-type doped region close to the isolation region is provided with n2 recessed structures, n1≥n2, and preferably, n1>n2. That is, when the silicon substrate is the N-type silicon substrate, the number of the recessed structures on the side of the P-type doped region close to the isolation region is greater than or equal to the number of the recessed structures on one side of the N-type doped region, the P-type doped region is an emitter, and by disposing more recessed structures in the P-type doped region, the collection of current is facilitated. Further, when the silicon substrate is the N-type silicon substrate, n2 can be 0.

Optionally, in order to facilitate the transmission and collection of the carriers and to reduce stress defects and risks of hidden cracks of cells, the distance between two adjacent recessed structures 17 on the side of the first region 13 close to the isolation region 15 is greater than 100 µm; and/or, the distance between two adjacent recessed structures 17 on the side of the second region 14 close to the isolation region 15 is greater than 100 µm.

Optionally, the side of the first region close to the isolation region includes a first target region, the length of the first target region in an extension direction of the isolation region is greater than 50 µm, and the first target region does not include the recessed structure; and the side of the second region close to the isolation region includes a second target region, the length of the second target region in the extension direction of the isolation region is greater than 50 µm, and the second target region does not include the recessed structure.

Correspondingly, the present disclosure further provides a method for preparing the back contact solar cell, including:
S1, providing a silicon substrate.
   Specifically, the silicon substrate can be an N-type silicon substrate or a P-type silicon substrate, and a non-illuminated side of the silicon substrate has first regions and second regions, wherein the first region and the second region are alternately disposed.
S2, forming a first doped conductive layer at least in the first region of the non-illuminated side of the silicon substrate, and forming a recessed structure on the surface of the first region.

The first doped conductive layer can be disposed in the silicon substrate or on the silicon substrate, preferably, a first tunneling layer and the first doped conductive layer are disposed in the first region on the non-illuminated side of the silicon substrate, and the first doped conductive layer can be a P-type doped conductive layer or an N-type doped conductive layer.

In a preferred implementation, the first tunneling layer and the first doped conductive layer are formed on the non-illuminated side of the silicon substrate, and at least the portion of the first tunneling layer located on the second region is processed to at least remove the portion of the first tunneling layer located on the second region, laser direct patterning and wet etching are used for processing, and a recessed structure is formed on the surface of the processed first doped conductive layer.

S3, forming a second doped conductive layer at least in the second region.

The second doped conductive layer can be disposed in the silicon substrate or on the silicon substrate, preferably, a second tunneling layer and the second doped conductive layer are disposed in the second region on the non-illuminated side of the silicon substrate, and the second doped conductive layer and the first doped conductive layer have opposite doping types.

In a preferred implementation, the second tunneling layer and the second doped conductive layer are formed on the non-illuminated side of the silicon substrate and the first doped conductive layer, and at least the portion of the second tunneling layer located on the first doped conductive layer is processed to at least remove the portion of the second tunneling layer located on the first doped conductive layer, laser direct patterning and wet etching are used for processing, and a recessed structure is formed on the surface of the processed first doped conductive layer.

S4, forming an isolation region between the first region and the second region.

In a preferred implementation, the portion of the second tunneling layer located between the first region and the second region is processed to remove the portion of the second tunneling layer located between the first region and the second region, so as to form the isolation region, laser direct patterning and wet etching are used for processing, and a recessed structure is formed on the surface of the processed second doped conductive layer.

Subsequently, passivation layers are deposited on the first doped conductive layer, the second doped conductive layer and the isolation region, so as to form a first electrode in contact with the first doped conductive layer and a second electrode in contact with the second doped conductive layer.

The present disclosure will be further described below with specific embodiments:

### Embodiment 1

The present embodiment provides a back contact solar cell, including P-type doped regions, N-type doped regions and isolation regions, which are disposed on a back surface of an N-type silicon substrate, wherein the P-type doped region and the N-type doped region are alternately disposed, the isolation region is located between the P-type doped region and the N-type doped region, the P-type doped region includes a P-type doped conductive layer, and the N-type doped region includes an N-type doped conductive layer. The side of the P-type doped region close to the isolation region is provided with a recessed structure.

The recessed structure includes a first recessed structure and a first unit region disposed around the first recessed structure, and the first recessed structure includes a pit and a protrusion disposed in the pit. Specifically, in a direction in which an illuminated side of the silicon substrate faces a non-illuminated side, the protrusion includes the silicon substrate and a passivation layer, a sidewall of the pit includes the passivation layer, and the first unit region includes the silicon substrate, a tunneling layer, the P-type doped conductive layer and the passivation layer, which are stacked in sequence. The width of the bottom of the protrusion is 0.1 µm to 1.5 µm, the height of the protrusion is 0.01 µm to 10 µm, the width of the opening of the pit is 0.1 µm to 2 µm, the depth of the pit is 0.01 µm to 10 µm, and the protrusion is in a pyramid shape.

### Embodiment 2

The present embodiment provides a back contact solar cell, including P-type doped regions, N-type doped regions and isolation regions, which are disposed on a back surface of an N-type silicon substrate, wherein the P-type doped region and the N-type doped region are alternately disposed, the isolation region is located between the P-type doped region and the N-type doped region, the P-type doped region includes a P-type doped conductive layer, and the N-type doped region includes an N-type doped conductive layer. The side of the P-type doped region close to the isolation region is provided with a recessed structure.

The recessed structure includes a first recessed structure and a first unit region disposed around the first recessed structure, and the first recessed structure includes a pit and a protrusion disposed in the pit. Specifically, in a direction in which an illuminated side of the silicon substrate faces a non-illuminated side, the protrusion includes the silicon substrate and a passivation layer, a sidewall of the pit includes the passivation layer, and the first unit region includes the silicon substrate, a tunneling layer, the P-type doped conductive layer and the passivation layer, which are stacked in sequence. The width of the bottom of the protrusion is 0.3 µm to 1.2 µm, the height of the protrusion is 0.05 µm to 2 µm, the width of the opening of the pit is 0.5 µm to 2 µm, the depth of the pit is 0.1 µm to 5 µm, and the protrusion is in a pyramid shape.

### Embodiment 3

The present embodiment provides a back contact solar cell, including P-type doped regions, N-type doped regions and isolation regions, which are disposed on a back surface of an N-type silicon substrate, wherein the P-type doped region and the N-type doped region are alternately disposed, the isolation regions is located between the P-type doped region and the N-type doped region, the P-type doped region includes a P-type doped conductive layer, and the N-type doped region includes an N-type doped conductive layer. The side of the P-type doped region close to the isolation region is provided with a recessed structure.

The recessed structure includes a first recessed structure and a first unit region disposed around the first recessed structure, and the first recessed structure includes a pit and a protrusion disposed in the pit. Specifically, in a direction in which an illuminated side of the silicon substrate faces a non-illuminated side, the protrusion includes the silicon substrate and a passivation layer, a sidewall of the pit includes the passivation layer, and the first unit region includes the silicon substrate, a tunneling layer, the P-type doped conductive layer and the passivation layer, which are stacked in sequence. The width of the bottom of the protrusion is 0.3 µm to 1.2 µm, the height of the protrusion is 0.05 µm to 2 µm, the width of the opening of the pit is 0.5 µm to 2 µm, the depth of the pit is 0.1 µm to 5 µm, and the protrusion is in a pyramid shape.

The P-type doped region includes an extension portion extending and protruding to the upper side of the isolation region, the recessed structure further includes a second recessed structure and a second unit region disposed around the second recessed structure, the second recessed structure penetrates through the extension portion to form a pore, and the width of the pore is 0.1 µm to 1.5 µm.

### Embodiment 4

The present embodiment provides a back contact solar cell, including P-type doped regions, N-type doped regions and isolation regions, which are disposed on a back surface of an N-type silicon substrate, wherein the P-type doped region and the N-type doped region are alternately disposed, the isolation regions is located between the P-type doped region and the N-type doped region, the P-type doped region includes a P-type doped conductive layer, and the N-type doped region includes an N-type doped conductive layer. The side of the P-type doped region close to the isolation region is provided with a recessed structure.

The recessed structure includes a first recessed structure and a first unit region disposed around the first recessed structure, and the first recessed structure includes a pit and a protrusion disposed in the pit. Specifically, in a direction in which an illuminated side of the silicon substrate faces a non-illuminated side, the protrusion includes the silicon substrate and a passivation layer, a sidewall of the pit includes the passivation layer, and the first unit region includes the silicon substrate, a tunneling layer, the P-type doped conductive layer and the passivation layer, which are stacked in sequence. The width of the bottom of the protrusion is 0.3 µm to 1.2 µm, the height of the protrusion is 0.05 µm to 2 µm, the width of the opening of the pit is 0.5 µm to 2 µm, the depth of the pit is 0.1 µm to 5 µm, and the protrusion is in a pyramid shape.

The P-type doped region includes an extension portion extending and protruding to the upper side of the isolation region, the recessed structure further includes a second recessed structure and a second unit region disposed around the second recessed structure, the second recessed structure penetrates through the extension portion to form a pore, and the width of the pore is 0.5 µm to 0.8 µm.

### Embodiment 5

The present embodiment provides a back contact solar cell, including P-type doped regions, N-type doped regions and isolation regions, which are disposed on a back surface of an N-type silicon substrate, wherein the P-type doped region and the N-type doped region are alternately disposed, the isolation regions is located between the P-type doped region and the N-type doped region, the P-type doped region includes a P-type doped conductive layer, and the N-type doped region includes an N-type doped conductive layer.

The side of the P-type doped region close to the isolation region is provided with a recessed structure.

The recessed structure includes a first recessed structure and a first unit region disposed around the first recessed structure, and the first recessed structure includes a pit and a protrusion disposed in the pit. Specifically, in a direction in which an illuminated side of the silicon substrate faces a non-illuminated side, the protrusion includes the silicon substrate and a passivation layer, a sidewall of the pit includes the passivation layer, and the first unit region includes the silicon substrate, a tunneling layer, the P-type doped conductive layer and the passivation layer, which are stacked in sequence. The width of the bottom of the protrusion is 0.3 µm to 1.2 µm, the height of the protrusion is 0.05 µm to 2 µm, the width of the opening of the pit is 0.5 µm to 2 µm, the depth of the pit is 0.1 µm to 5 µm, and the protrusion is in a pyramid shape.

The P-type doped region includes an extension portion extending and protruding to the upper side of the isolation region, the recessed structure further includes a second recessed structure and a second unit region disposed around the second recessed structure, the second recessed structure penetrates through the extension portion to form a pore, and the width of the pore is 0.5 µm to 0.8 µm.

The side of the N-type doped region close to the isolation region is also provided with a first recessed structure. The number of the first recessed structures of the N-type doped regions is less than the number of the first recessed structures of the P-type doped regions. The remaining features are the same as those in Embodiment 1.

After electrode printing and sintering alloying are performed on the back contact solar cells prepared in Embodiment 1 to Embodiment 5, an annealing treatment is performed to obtain finished solar cells, the power conversion efficiency of the finished solar cell is measured, and results are shown in the following table.

| | Power conversion efficiency |
|---|---|
| Embodiment 1 | 26.68% |
| Embodiment 2 | 26.72% |
| Embodiment 3 | 26.75% |
| Embodiment 4 | 26.77% |
| Embodiment 5 | 26.79% |

The back contact solar cell in the present disclosure includes a silicon substrate, a first tunneling layer and a first doped conductive layer, the silicon substrate has a front surface and a back surface opposite to each other, the back surface is provided with several first regions and several second regions, wherein the first region and the second region are sequentially and alternately arranged in a first direction, adjacent first region and second region are spaced apart by isolation region, the first doped conductive layer is disposed on the silicon substrate of the first region, the first tunneling layer is disposed between the first doped conductive layer and the silicon substrate of the first region, the first doped conductive layer, the tunneling layer and an edge of the silicon substrate of the first region all extend towards the center of the opening of the isolation region to form an extension portion, or only the first doped conductive layer extends towards the center of the opening of the isolation region to form the extension portion, and the extension portion is provided with a second recessed structure. By disposing the extension portion, the opening of the isolation region becomes smaller, therefore the exchange between plasma and outside can be reduced during subsequent deposition of the passivation layer, and localized distribution of hydrogen content of the passivation layer is realized, so that the content of movable oxygen of the passivation layer in the isolation region is lower, and the content of movable oxygen of the passivation film layer on remaining regions is higher, thus the passivation and anti-attenuation effects can be effectively improved; and in addition, by disposing the second recessed structure on the extension portion, recognition and alignment of subsequent procedures are facilitated, meanwhile, the passivation of a polycrystalline silicon film is not affected, thereby ensuring the conversion efficiency of the solar cell.

### Embodiment 6

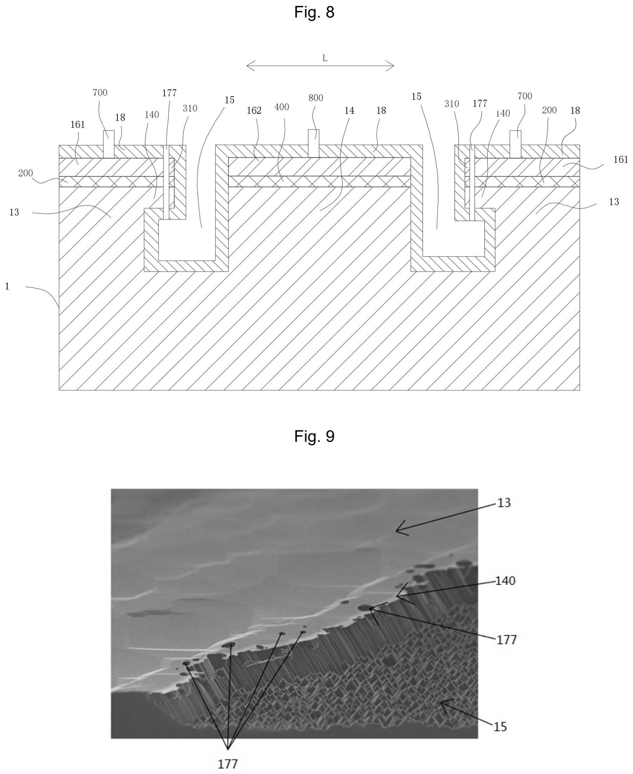

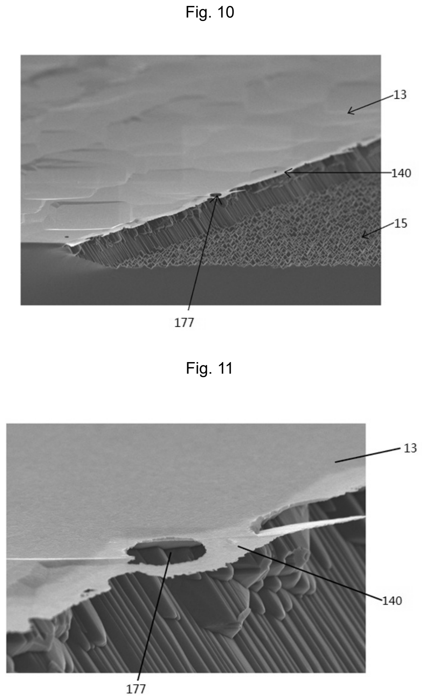

As shown in Fig. 8 to Fig. 17, one embodiment of the present disclosure provides a back contact solar cell, including: a silicon substrate 1, wherein the silicon substrate 1 has an illuminated side 11 and a non-illuminated side 12 which are opposite to each other, the non-illuminated side 12 is arranged with several first regions 13 and several second regions 14, wherein the first region 13 and the second region 14 are sequentially and alternately arranged in a first direction, and each adjacent first region 13 and second region 14 are spaced apart by an isolation region 15;
first doped conductive layers 161, disposed on the silicon substrate 1 of the first regions 13; and first tunneling layers 200, disposed between the first doped conductive layers 161 and the silicon substrate 1 of the first regions 13;
the edges of the first doped conductive layers 161, the first tunneling layers 200 and the silicon substrate 1 of the first regions 13 all extend towards the central direction of the isolation region opening 15 to form extension portions, or only the first doped conductive layers 161 extend towards the central direction of the isolation region opening 15 to form extension portions; and
extension portions have second recessed structures 177.
silicon substrate 1 is in the shape of a sheet or a plate, the silicon substrate 1 has the illuminated side 11 and the non-illuminated side 12 opposite to each other.

Optionally, in some embodiments, the silicon substrate 1 is an N-type silicon wafer, and in some embodiments, the silicon substrate 1 is a P-type silicon wafer, which is not limited, wherein the N-type silicon wafer is obtained by doping a pentavalent element (e.g., phosphorus, arsenic or bismuth, or the like) into an intrinsic semiconductor, the P-type silicon wafer is obtained by adding a trivalent element (e.g., boron, gallium or indium, or the like) into the intrinsic semiconductor, and no repeated description is given.

During implementation, several isolation regions 15 arranged at intervals are formed on the non-illuminated side 12 of the silicon substrate 1, and the non-illuminated side 12 is divided by the isolation regions 15 into the several first regions 13 and several second regions 14 which are sequentially and alternately arranged, that is, each adjacent first region 13 and second region 14 are spaced apart by the isolation region 15.

In some optional embodiments, the first direction is a horizontal transverse direction, as shown in Fig. 8, the extension direction of a line segment L is the first direction, the first regions 13 and the second regions 14 are alternately arranged in the horizontal transverse direction of the silicon substrate 1, and the isolation regions 15 extend in the longitudinal direction to space apart the adjacent first regions 13 and second regions 14.

During implementation, the first regions 13 and the second regions 14 are respectively regions having opposite doping types of the solar cell, for example, it is taken as an example that the silicon substrate 1 is an N-type silicon wafer, a trivalent element is doped on the basis of the N-type silicon wafer to obtain an emitter region, at this time, the emitter region can be regarded as a p+ layer, and similarly, a pentavalent element is doped on the basis of the N-type silicon wafer to obtain a doped diffusion layer, and at this time, the doped diffusion layer can be regarded as an n+ layer. When the first regions 13 are p+ layers, the second regions 14 are n+ layers, and similarly, when the first regions 13 are n+ layers, the second regions 14 are p+ layers.

The first tunneling layers 200 and the first doped conductive layers 161 are stacked on the first regions 13, wherein the edges of the first tunneling layers 200, the first doped conductive layers 161 and the silicon substrate 1 of the first regions 13 all extend towards the central direction of the isolation region opening 15 to form the extension portions, that is, the first tunneling layers 200, the first doped conductive layers 161 and the silicon substrate 1 of the first regions 13 all protrude towards the isolation region opening 15 to form the extension portions, so that the isolation regions 15 form recessed structures with small openings and large interiors.

During implementation, the isolation regions 15 and the extension portions on the silicon substrate 1 can be formed in a combined mode of grooving and etching, for example, an opening extending in a second direction is first formed on the silicon substrate 1 in a mechanical or chemical etching mode, the second direction is perpendicular to the first direction, and then the opening is etched in an acid etching or alkali etching mode. Since the corrosion resistance of the first tunneling layers 200 and the first doped conductive layers 161 is different from the corrosion resistance of the silicon substrate 1, in general, the corrosion resistance of the first tunneling layers 200 and the first doped conductive layers 161 is better than the corrosion resistance of the silicon substrate 1, when the opening is etched in the acid etching or alkali etching mode, the silicon substrate 1 is quickly etched, the first tunneling layers 200 and the first doped conductive layers 161are slowly etched or even are not etched, so that the etching rate of the portion of the silicon substrate 1 close to the first tunneling layers 200 and the first doped conductive layers 161 is reduced, accordingly, the edges of the silicon substrate 1 of the first regions 13 close to the isolation regions 15 protrudes to form first extension portions 140 of the silicon substrate 1 of the first regions 13, and the first doped conductive layers 161 and the first tunneling layers 200 protrude from the isolation regions 15 to form second extension portions 310, as shown in Fig. 8. By forming recessed regions (i.e., the isolation regions 15) with small openings and large interiors, the exchange between the plasma and the outside during subsequent deposition of passivation film layers is reduced. It can be understood that in this embodiment, the extension portions formed by extending the edges of the first doped conductive layers 161, the first tunneling layers 200 and the silicon substrate 1 of the first regions 13 towards the central direction of the isolation region opening 15 include the first extension portions 140 and the second extension portions 310, as shown in Fig. 8.

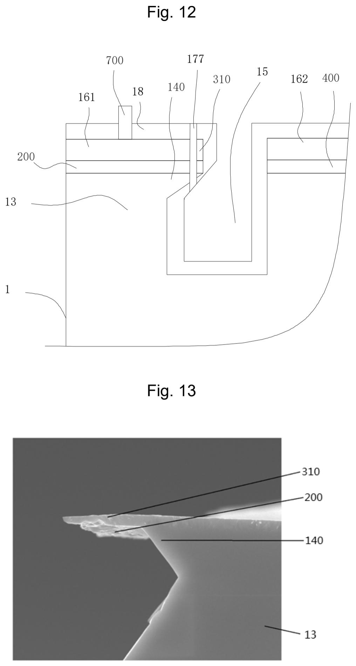

In some embodiments, when acid etching or alkali etching is performed on the silicon substrate 1, the silicon substrate 1 is quickly etched, and the etching rate of the portions of the silicon substrate 1 close to the first tunneling layers 200 and the first doped conductive layers 161 is reduced, so that side walls of the silicon substrate 1 of the first regions 13 become tapered walls to form the first extension portions 140, and the edges of the first tunneling layers 200 and the first doped conductive layers 161 close to the isolation regions 15 protrude to form the second extension portions 310, as shown in Fig. 12 and Fig. 13, thereby forming recessed regions with small openings and large interiors.

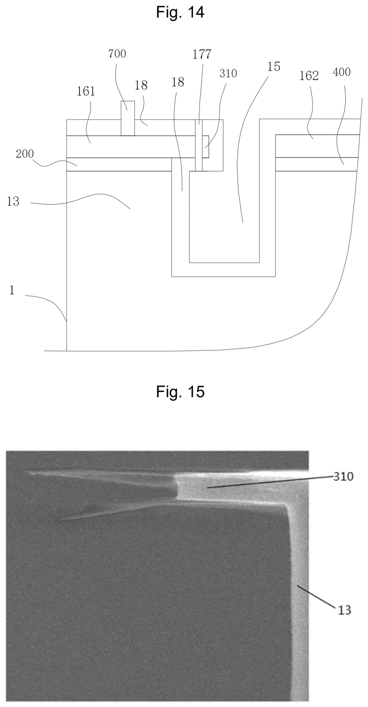

In some possible embodiments, only the first doped conductive layers 161 have the second extension portions 310, for example, an opening extending in the second direction is first formed on the silicon substrate 1 in the mechanical or chemical etching mode, and then the opening is etched in the acid etching or alkali etching mode, wherein the side walls of the silicon substrate 1 of the first regions 13 become vertical walls, the portions of the first tunneling layers 200 and the first doped conductive layers 161 close to the isolation regions 15 protrude, then the protruding first tunneling layers 200 are washed away by a subsequent cleaning process, and only the protruding portions of the first doped conductive layers 161 are retained, that is, only the first doped conductive layers 161 extend towards the central direction of the isolation region opening 15 to form the second extension portions 310, thereby forming the recessed regions with the small openings and the large interiors, as shown in Fig. 14 and Fig. 15. It can be understood that in this embodiment, the extension portions formed by the first doped conductive layers 161 extending towards the central direction of the isolation region opening 15 are the second extension portions 310, as shown in Fig. 14 and Fig. 15.

Optionally, the extension portion enables the isolation region 15 to become a structure with a small opening and a large interior, therefore the length of the extension portion needs to be controlled within a certain reasonable range. Exemplarily, the length of the extension portion can be designed to be 0.1 µm to 40 µm, for example, 0.2 µm, 0.3 µm, 25 µm, 30 µm, 35 µm, or any numerical value between 0.1 µm and 40 µm, preferably, the length of the extension portion is 0.5 µm to 20 µm, for example, 0.6 µm, 0.7 µm, 1 µm, 5 µm, 6 µm, 7 µm, 8 µm, 9 µm, 10 µm, 11 µm, 15 µm, or any numerical value between 0.5 µm and 20 µm, which is not limited. By the above settings, the length of the extension portion is set within this reasonable range, thereby avoiding the situation in which the function of effectively reducing the exchange between the plasma and the outside during the deposition of the passivation film layer cannot be effectively achieved due to an excessively small length of the extension portion, avoiding the situation in which the etching process difficulty is excessively large caused by an excessively small opening of the isolation region 15 due to the fact that the length of the extension portion is too large, and also avoiding the situation in which the extension portion is prone to breakage due to an excessively large length.

As shown in Fig. 14, when only the first doped conductive layers 161 have the second extension portions 310, only the second extension portions 310 of the first doped conductive layers 161 have second recessed structures 177.

When the first doped conductive layers 161, the first tunneling layers 200 and the silicon substrate 1 of the first regions 13 are all arranged with extension portions, for example, in the structure as shown in Fig. 15 and Fig. 12, the first doped conductive layers 161 and the first tunneling layers 200 are arranged with the second extension portions 310, the first regions 13 are arranged with the first extension portions 140, and at this time, the second extension portions 310 and the first extension portions 140 all have second recessed structures 177.

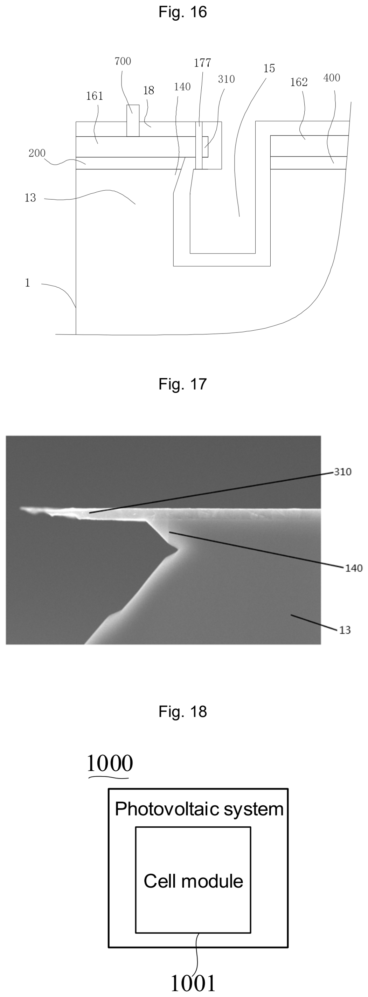

It should be noted that the film layer structures being arranged with the extension portions and the forms of the extension portions are an example of the embodiments of the present disclosure, rather than specifically limiting the present disclosure, and in some other embodiments, other structural forms can also be designed. For example, in some embodiments, when acid etching or alkali etching is performed on the silicon substrate 1, the silicon substrate 1 is quickly etched, and the etching rate of the portions of the silicon substrate 1 close to the first tunneling layers 200 and the first doped conductive layers 161 is reduced, so that the side walls of the silicon substrate 1 of the first regions 13 become tapered walls to form the first extension portions 140, the portions of the first tunneling layers 200 and the first doped conductive layers 161 close to the isolation regions 15 protrude and exceed the first extension portions 140, then the protruding first tunneling layers 200 are washed away by a subsequent cleaning process, only the protruding portions of the first doped conductive layer 161 are retained to form the second extension portions 310, and only the second extension portions 310 have the second recessed structures 177 as shown in Fig. 16 and Fig. 17, which is not limited. It can be understood that in this embodiment, the extension portions formed by extending the edges of the first doped conductive layers 161, the first tunneling layers 200 and the silicon substrate 1 of the first regions 13 towards the central direction of the isolation region opening 15 include the first extension portions 140 and the second extension portions 310, as shown in Fig. 16 and Fig. 17.

During implementation, the second recessed structures 177 are second recessed structures 177 formed by laser when the film layers are removed by using laser during the preparation of the back contact solar cell, for example, when the passivation layer or a BSG (Back Surface Field Silicon Wafer) is removed by using laser, the laser will etch the second recessed structures 177 in the portions of the first doped conductive layers 161 and/or the first tunneling layers 200 that are located on the extension portions.

Optionally, the diameter of the second recessed structure 177 is 0.1 µm to 5 µm, for example, 0.2 µm, 0.5 µm, 1 µm, 2 µm, 3 µm, or 4 µm, which is not limited.

In some possible embodiments, the second recessed structure 177 is a blind hole or a punch hole, the type of the second recessed structure 177 can be a blind hole or a punch hole, and specifically, the type of the second recessed structure 177 is determined by the duration and power of laser irradiation on a position where the second recessed structure 177 is located, for example, in the case of fixed power, the first second recessed structure 177 is subjected to a shorter laser irradiation duration, so that the first second recessed structure 177 is a blind hole, and the second second recessed structure 177 is subjected to a longer laser irradiation duration, so that the second second recessed structure 177 is a punch hole, which is not limited.

During the subsequent deposition of the passivation layers, these second recessed structures 177 can further reduce the exchange between the plasma in the isolation regions 15 and the outside, so as to further improve the passivation and anti-attenuation effects.

The back contact solar cell of the present disclosure includes the silicon substrate 1, the first tunneling layers 200 and the first doped conductive layers 161, the silicon substrate 1 has the illuminated side 11 and the non-illuminated side 12 which are opposite to each other, the non-illuminated side 12 is arranged with several first regions 13 and several second regions 14, wherein the first region and second region are sequentially and alternately arranged in the first direction, each adjacent first region 13 and second region 14 are spaced apart by the isolation region 15, the first doped conductive layers 161 are disposed on the silicon substrate 1 of the first regions 13, the first tunneling layers 200 are disposed between the first doped conductive layers 161 and the silicon substrate 1 of the first regions 13, the edges of the first doped conductive layers 161, the tunneling layers 200 and the silicon substrate 1 of the first regions 13 all extend towards the central direction of the isolation region opening 15 to form the extension portions, or only the first doped conductive layers 161 extend towards the central direction of the isolation region opening 15 to form the extension portions, and the extension portion has the second recessed structure 177. By disposing the extension portions, the isolation region opening 15 become smaller, the exchange between plasma and the outside can be reduced during subsequent deposition of the passivation layers, and the partial distribution of hydrogen content of the passivation layers can be realized, so that the content of movable oxygen of the passivation layers in the isolation regions 15 is lower, and the content of movable oxygen of passivation film layers on the remaining regions is higher, therefore the passivation and anti-attenuation effects can be effectively improved; and in addition, by forming the second recessed structures 177 in the extension portions, identification and alignment of subsequent processes are facilitated, meanwhile, the passivation of a polysilicon film is not affected, and the conversion efficiency of the solar cell is ensured.

In some possible embodiments, the back contact solar cell provided in the present disclosure further includes second tunneling layers 400 and second doped conductive layers 162; and
the second doped conductive layers 162 are disposed on the silicon substrate 1 of the second regions 14, and the second tunneling layers 400 are disposed between the second doped conductive layers 162 and the silicon substrate 1 of the second regions 14.

During implementation, the first doped conductive layer 161 can be one of a P-type doped layer and an N-type doped layer, and the second doped conductive layer 162 can be the other of the P-type doped layer and an N-type doped layer, for example, in some embodiments, the first doped conductive layer 161 can be a P-type doped layer, the second doped conductive layer 162 can be an N-type doped layer, and both the first tunneling layer 200 and the second tunneling layer 400 can be one or combinations of more of a tunneling oxide layer (e.g., a tunneling silicon oxide layer), an intrinsic silicon carbide layer, and an intrinsic amorphous silicon layer, which is not specifically limited herein. The first tunneling layer 200 and/or the second tunneling layer 400 includes at least one of an amorphous silicon layer, a silicon oxide layer, a silicon nitride layer, a silicon oxynitride layer, a silicon carbon oxynitride layer, a titanium oxide layer, a hafnium oxide layer, and an aluminum oxide layer.

In some optional embodiments, the back contact solar cell provided in the present disclosure further includes passivation layers 18, first electrodes 700 and second electrodes 800, wherein the passivation layers 18 cover the first doped conductive layers 161, the second doped conductive layers 162 and the isolation regions 15, the first electrodes 700 pass through the passivation layers 18 to be connected with the first doped conductive layers 161, the second electrodes 800 pass through the passivation layers 18 to be connected with the second doped conductive layers 162, and the first electrodes 700 and the second electrodes 800 are all metal electrodes.

The passivation layer 18 is a passivation anti-reflection thin film, and the passivation anti-reflection thin film is used for improving the photoelectric conversion efficiency and stability of the solar cell, reducing the surface damage and oxidation reaction of the solar cell, and prolonging the service life of the solar cell.

Optionally, the passivation layer 18 includes at least one of an amorphous silicon layer, a silicon oxide layer, a silicon nitride layer, a silicon oxynitride layer, a silicon carbon oxynitride layer, a titanium oxide layer, a hafnium oxide layer, and an aluminum oxide layer, which is not limited.

Optionally, the non-illuminated side 12 of the silicon substrate 1 can be a polished surface or a textured surface, the textured surface can be a surface having a relatively high roughness, such as a suede, which reduces the reflection of light, increases the absorption of light, changes an incident angle and a propagation path of the light, forms a light trap, and improves the density of photon-generated carriers, thereby improving the photoelectric conversion rate of the cell.

### Embodiment 7

In some optional embodiments, the present disclosure further provides a photovoltaic module, including the back contact solar cell as described above.

It can be understood that, the photovoltaic module can further include a metal frame, a backsheet, photovoltaic glass and an adhesive film (not shown), wherein the adhesive film can be filled between the illuminated side 11 of the back contact solar cell and the photovoltaic glass, can also be filled between the non-illuminated side 12 of the back contact solar cell and the backsheet, and filled between adjacent back contact solar cells. As a filler, the adhesive film can be a transparent colloid with good light transmittance and aging resistance, for example, the adhesive film can be an EVA (ethylene-vinyl acetate copolymer) adhesive film or a POE (Polyolefin elastomer) adhesive film, which can be specifically selected according to actual situations and is not limited herein. The photovoltaic glass can cover the adhesive film on the illuminated side 11 of the back contact solar cell, the photovoltaic glass can be ultra-clear glass, which has high light transmittance and high transparency, and has excellent physical, mechanical and optical properties, for example, the light transmittance of the ultra-clear glass can reach more than 92%, and the ultra-clear glass can protect the back contact solar cell without affecting the efficiency of the back contact solar cell as much as possible. Meanwhile, the adhesive film can bond the photovoltaic glass and the back contact solar cell together, and the adhesive film can seal and insulate the back contact solar cell and prevent water and moisture.

The backsheet can be attached to the adhesive film on the non-illuminated side 12 of the back contact solar cell, the backsheet can protect and support the back contact solar cell and has reliable insulation, water resistance and aging resistance, the backsheet can have multiple choices and can generally be tempered glass, organic glass, an aluminum alloy-TPT (Tedlar/PET/Tedlar) composite adhesive film, and the like, which can be specifically set according to specific conditions and is not limited herein.

An entirety consisting of the backsheet, the back contact solar cell, the adhesive film and the photovoltaic glass can be disposed on the metal frame, the metal frame serves as a main external supporting structure of the entire photovoltaic module and can provide stable support and installation for the photovoltaic module, for example, the photovoltaic module can be installed at a required position via the metal frame.

It can be clearly understood by those skilled in the art to which the present disclosure belongs that, for the convenience and conciseness of description, regarding the structures and implementation principles of the photovoltaic module described above, reference can be made to corresponding structures and implementation principles in the foregoing Embodiment 1, and thus details are not described herein again.

A back contact solar cell of the present disclosure includes a silicon substrate 1, first tunneling layers 200 and first doped conductive layers 161, the silicon substrate 1 has an illuminated side 11 and a non-illuminated side 12 which are opposite to each other, the non-illuminated side 12 is arranged with several first regions 13 and several second regions 14, wherein the first region and second region are sequentially and alternately arranged in a first direction, each adjacent first region 13 and second region 14 are spaced apart by the isolation region 15, the first doped conductive layers 161 are disposed on the silicon substrate 1 of the first regions 13, the first tunneling layers 200 are disposed between the first doped conductive layers 161 and the silicon substrate 1 of the first regions 13, the edges of the first doped conductive layers 161, the first tunneling layers 200 and the silicon substrate 1 of the first regions 13 all extend towards the central direction of the isolation region opening 15 to form extension portions, or only the first doped conductive layers 161 extend towards the central direction of the isolation region opening 15 to form extension portions, and the extension portions have second recessed structures 177. By disposing the extension portions, the isolation region opening 15 become smaller, the exchange between plasma and the outside can be reduced during subsequent deposition of passivation layers, and the partial distribution of hydrogen content of the passivation layers can be realized, so that the content of movable oxygen of the passivation layers in the isolation regions 15 is lower, and the content of movable oxygen of passivation film layers on the remaining regions is higher, therefore the passivation and anti-attenuation effects can be effectively improved; and in addition, by forming the second recessed structures 177 in the extension portions, identification and alignment of subsequent processes are facilitated, meanwhile, the passivation of a polysilicon film is not affected, and the conversion efficiency of the solar cell is ensured.

### Embodiment 8

In some optional embodiments, the present disclosure further provides a photovoltaic system, including the photovoltaic module as described above.

During implementation, the photovoltaic system can be applied to a photovoltaic power station, for example, a ground power station, a roof power station, a water surface power station, and the like, can also be applied to devices or apparatuses that utilize solar energy for power generation, for example, user solar power supplies, solar street lamps, solar vehicles, solar buildings, and the like. Of course, it can be understood that the application scenarios of the photovoltaic system are not limited thereto, that is, the photovoltaic system can be applied to all fields where power generation needs to be performed by using solar energy. Taking a photovoltaic power generation system network as an example, the photovoltaic system can include a photovoltaic array, a combiner box and an inverter, the photovoltaic array can be an array combination of a plurality of photovoltaic assemblies, for example, the plurality of photovoltaic assemblies can form a plurality of photovoltaic arrays, the photovoltaic array is connected with the combiner box, the combiner box can converge current generated by the photovoltaic array, and the converged current flows through the inverter to be converted into alternating current required by a mains power grid and then is connected to a mains supply network to realize solar power supply.

It can be clearly understood by those skilled in the art to which the present disclosure belongs that, for the convenience and conciseness of description, regarding the structures and implementation principles of the photovoltaic module described above, reference can be made to corresponding structures and implementation principles in the foregoing Embodiment 1 and Embodiment 2, and thus details are not described herein again.

A back contact solar cell of the present disclosure includes a silicon substrate 1, first tunneling layers 200 and first doped conductive layers 161, the silicon substrate 1 has an illuminated side 11 and a non-illuminated side 12 which are opposite to each other, the non-illuminated side 12 is arranged with several first regions 13 and several second regions 14, wherein the first region and second region are sequentially and alternately arranged in a first direction, each adjacent first region 13 and second region 14 are spaced apart by the isolation region 15, the first doped conductive layers 161 are disposed on the silicon substrate 1 of the first regions 13, the first tunneling layers 200 are disposed between the first doped conductive layers 161 and the silicon substrate 1 of the first regions 13, the edges of the first doped conductive layers 161, the first tunneling layers 200 and the silicon substrate 1 of the first regions 13 all extend towards the central direction of the isolation region opening 15 to form extension portions, or only the first doped conductive layers 161 extend towards the central direction of the isolation region opening 15 to form extension portions, and the extension portions have second recessed structures 177. By disposing the extension portions, the isolation region opening 15 become smaller, the exchange between plasma and the outside can be reduced during subsequent deposition of passivation layers, and the partial distribution of hydrogen content of the passivation layers can be realized, so that the content of movable oxygen of the passivation layers in the isolation regions 15 is lower, and the content of movable oxygen of passivation film layers on the remaining regions is higher, therefore the passivation and anti-attenuation effects can be effectively improved; and in addition, by forming the second recessed structures 177 in the extension portions, identification and alignment of subsequent processes are facilitated, meanwhile, the passivation of a polysilicon film is not affected, and the conversion efficiency of the solar cell is ensured.

Referring to Fig. 18 to Fig. 19, a photovoltaic system 1000 in the embodiments of the present disclosure can include a cell module 1001 in the embodiments of the present disclosure, and the cell module 1001 in the embodiments of the present disclosure can include a plurality of back contact solar cells 100 in the embodiments of the present disclosure.

In the embodiments of the present disclosure, the plurality of back contact solar cells 100 in the cell module 1001 can be connected in series to form a plurality of cell strings, and the cell strings can be connected in series, in parallel, or a serial-parallel combined manner to realize confluence output of current, for example, cells can be connected by welding ribbons, and the cell strings can be connected by a busbar. In some embodiments, the cell strings can form cell arrays, and then the cell arrays are packaged together by a front plate, a front adhesive film, a rear adhesive film and a back plate to form the cell module 1001.

In some optional implementations, a back contact solar cell includes first regions and second regions, which are disposed on a non-illuminated side of a silicon substrate, the first region and the second region are alternately disposed, the first regions include first doped conductive layers, the second regions include second doped conductive layers, and the first doped conductive layers and the second doped conductive layers have opposite doping types; the alternate arrangement direction of the first region and the second region is a first direction, the first regions and the second regions all extend in a third direction, the first direction intersects with the third direction, and the back contact solar cell includes several first doped conductive layers and several second doped conductive layers; the first doped conductive layers cover at least part of the first regions, each first region is provided with the first doped conductive layer, and first recessed structures are formed on at least part of the first doped conductive layers; and the second doped conductive layers cover at least part of the second regions, each second region is provided with the second doped conductive layer, at least part of the second doped conductive layers are provided with leakage-prone contacts extending onto the first doped conductive layers, the leakage-prone contacts extend into the first recessed structures, and the leakage-prone contact are in leakage contact with the first doped conductive layers at least in the first recessed structures.

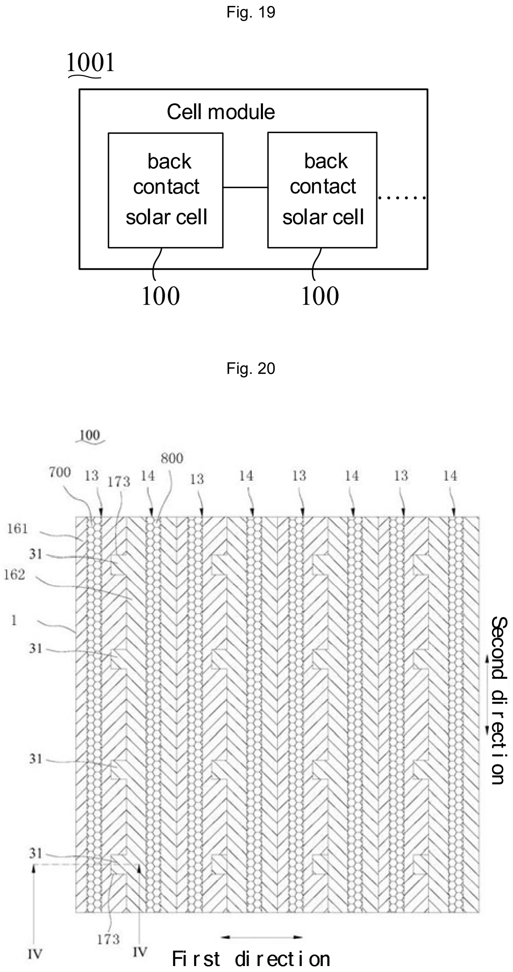

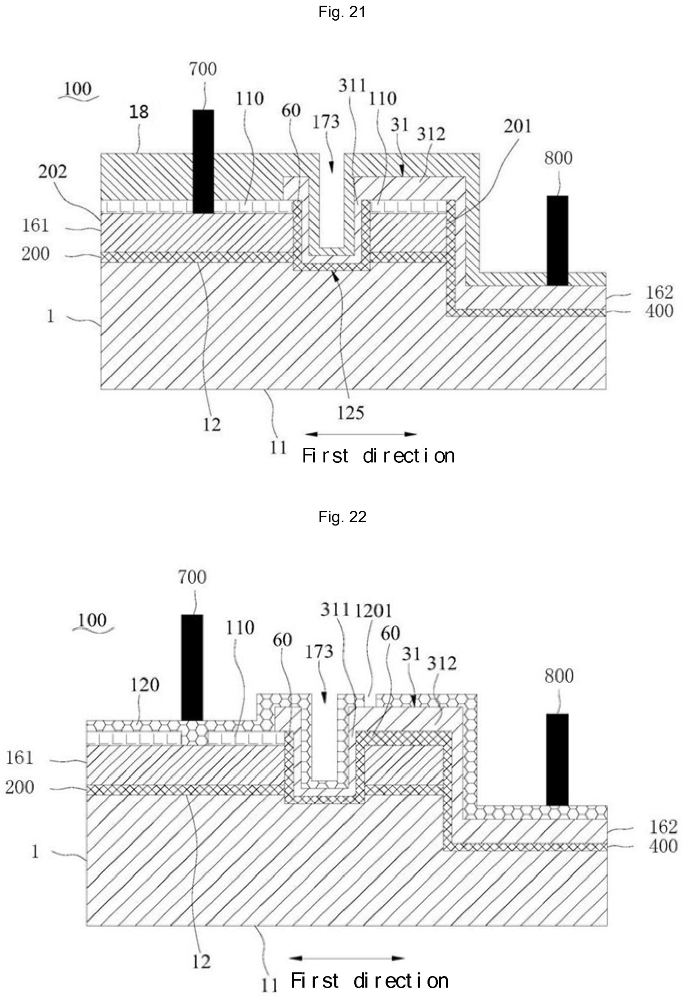

Specifically, referring to Fig. 20 and Fig. 21, the back contact solar cell 100 in the embodiments of the present disclosure can include a silicon substrate 1, several first doped conductive layers 161, and several second doped conductive layers 162.

The silicon substrate 1 has an illuminated side 11 and a non-illuminated side 12 opposite to each other, the non-illuminated side 12 includes first regions 13 and second regions 14, wherein the first region 13 and second region 14 are alternately arranged in the first direction, the first regions 13 and the second regions 14 all extend in the third direction, and the third direction intersects with the first direction.

Specifically, as shown in Fig. 20, the first regions 13 and the second regions 14 can be alternately arranged in a transverse direction of the silicon substrate 1 and extend in a longitudinal direction, that is, the first direction can be the transverse direction of the back contact solar cell 100, the third direction can be the transverse direction of the back contact solar cell 100, and the two directions are perpendicular to each other. Of course, in other embodiments, the first direction and the third direction can also be other directions, for example, the two directions can be respectively diagonal directions of the silicon substrate 1, which is not specifically limited herein. The first doped conductive layers 161 are disposed on the first regions 13 and cover at least part of the first regions 13, each first region 13 is provided with the first doped conductive layer 161, the number of the first doped conductive layers 161 corresponds to the number of the first regions 13, and first recessed structures 173 are formed on at least part of the first doped conductive layers 161.

The second doped conductive layers 162 are disposed on the second regions 14 and cover at least part of the second regions 14, each second region 14 is provided with the second doped conductive layer 162, the number of the second doped conductive layers 162 corresponds to the number of the second regions 14, at least part of the second doped conductive layers 162 are provided with leakage-prone contacts 31 extending onto the first doped conductive layers 161, the leakage-prone contacts 31 partially extend into the first recessed structures 173, and the leakage-prone contacts 31 are in leakage contact with the first doped conductive layers 161 at least in the first recessed structures 173.

It should be noted that herein, a certain layer of structure covers a part of or all regions of a certain surface can be that a certain layer of structure covers another layer of structure, or the layer of structure is directly stacked on the surface or a certain film layer, or another film layer is further disposed between the film layer and the surface or between the film layers, and the coverage is merely used to limit the specific setting range of the film layer.

In addition, it should also be noted that herein, "leakage contact" means that the leakage-prone contact 31 and the first doped conductive layer 161 are not insulated, but are in electric leakage conduction with each other to form an electric leakage point, the leakage-prone contact 31 and the first doped conductive layer 161 can be in direct contact to form a leakage point location, and tunneling can also be achieved by other dielectric layers to achieve a leakage contact function, for example, the leakage-prone contact 31 and the first doped conductive layer 161 are directly provided with dielectric layers (e.g., tunneling oxide layers, and the like) having electric conduction functions.

In the back contact solar cell 100, the cell module 1001 and the photovoltaic system 1000 in the embodiments of the present disclosure, the first recessed structures 173 are formed on at least part of the first doped conductive layers 161, the second doped conductive layers 162 are provided with the leakage-prone contacts 31 extending onto the first doped conductive layers 161, and the leakage-prone contacts 31 partially extend into the first recessed structures 173 and form leakage contact with the first doped conductive layers 161 at least in the first recessed structures 173. In this way, the leakage-prone contacts 31 of the second doped conductive layers 162 can form leakage contact with the first doped conductive layers 161 in the first recessed structures 173, thereby forming leakage point locations at the first recessed structures 173, which can reduce a reverse breakdown voltage when the back contact solar cell 100 is shaded, thereby improving the hot spot resistance of the back contact solar cell 100 and reducing the hot spot risk of the cell module 1001. Meanwhile, by disposing the first recessed structures 173, the accuracy of the contact area can be ensured while the leakage contact area is improved, the hot spot resistance of the back contact solar cell 100 is further optimized, and the consistency of the hot spot resistance of the back contact solar cells 100 in a production process is ensured.

Specifically, in the embodiments of the present disclosure, the silicon substrate 1 can be an N-type silicon substrate 1 or a P-type silicon substrate 1, which is not specifically limited herein. The first doped conductive layer 161 can be an N-type doped layer and the second doped conductive layer 162 can be a P-type doped layer, or the first doped conductive layer 161 is a P-type doped layer and the second doped conductive layer 162 is an P-type doped layer, which is not specifically limited herein, as long as the first doped conductive layer 161 and the second doped conductive layer 162 have opposite polarities.

In the embodiments of the present disclosure, at least one first recessed structure 173 can be formed on all first doped conductive layers 161, and all second doped conductive layers 162 are provided with at least one leakage-prone contact 31, or the first recessed structures 173 are formed on all first doped conductive layers 161, and a part of the second doped conductive layers 162 are provided with the leakage-prone contacts 31, or the first recessed structures 173 are formed on a part of the first doped conductive layers 161, and a part of the second doped conductive layers 162 are provided with the leakage-prone contacts 31, which is not specifically limited herein, as long as the efficiency of the back contact solar cell 100 is not greatly reduced by the leakage contact area, for example, the efficiency loss is controlled within 0.3%.

Referring to Fig. 21, in some embodiments, a first tunneling layer 200 is disposed between the first doped conductive layer 161 and the silicon substrate 1 in the first region 13, and a second tunneling layer 400 is disposed between the second doped conductive layer 162 and the silicon substrate 1 in the second region 14.

In this way, by disposing the first tunneling layer 200 and the second tunneling layer 400, the passivation effect can be improved. Specifically, both the first tunneling layer 200 and the second tunneling layer 400 can be film layers, such as tunneling oxide layers, intrinsic amorphous silicon layers, etc.

Still referring to Fig. 21, in some embodiments, a dielectric layer 60 is disposed on a region in the first recessed structure 173 that is covered by the leakage-prone contact 31, the leakage-prone contact 31 covers the dielectric layer 60, and the leakage-prone contact 31 is in leakage contact with the first doped conductive layer 161 in the first recessed structure 173 by the dielectric layer 60.

In this way, by disposing the dielectric layer 60, the leakage-prone contact 31 can form a leakage contact with the first doped conductive layer 161 while the passivation effect is improved, thereby improving the thermal spot resistance while improving the passivation effect. The dielectric layer 60 can be a film layer having a conductive function, such as a tunneling oxide layer.

As shown in Fig. 21, in some embodiments, both the first doped conductive layer 161 and the second doped conductive layer 162 can be doped polysilicon layers, and both the first tunneling layer 200 and the second tunneling layer 400 are tunneling oxide layers.

As shown in Fig. 21, in this case, the entire non-illuminated side 12 is further covered with the passivation layer 18, the passivation layer 18 is an outermost layer of the non-illuminated side 12 of the back contact solar cell 100, a first electrode 700 is disposed above the first doped conductive layer 161, a second electrode 800 is disposed above the second doped conductive layer 162, the first electrode 700 can penetrate through the passivation layer 18 to form a conductive connection with the first doped conductive layer 161, the second electrode 800 can penetrate through the passivation layer 18 to form a conductive connection with the second doped conductive layer 162, and the first electrode 700 and the second electrode 800 can be formed in such manners as firing-through or groove-filling deposition and electroplating.

It can be understood that in such an embodiment, since the leakage-prone contact 31 of the second doped conductive layer 162 extends to the upper side of the first doped conductive layer 161, the first electrode 700 needs to avoid the leakage-prone contact 31. Therefore, in one embodiment, the first electrode 700 can be disposed on one side of the leakage-prone contact 31, the first electrode 700 does not overlap with the leakage-prone contact 31 in the thickness direction, and the first electrode 700 can be continuously disposed, by using firing-through paste, on the portion of the first doped conductive layer 161 that is not covered by the leakage-prone contact 31 in the third direction. Of course, an electrode groove continuously extending in the third direction can also be formed in the passivation layer 18, and then the first electrode 700 is formed at the electrode groove in such manners as deposition and electroplating. Of course, the first electrode 700 can also at least partially overlap with the leakage-prone contact 31 in the thickness direction, in this case, interrupted spacing grooves are formed in the passivation layer 18 at first, that is, electrode grooves are formed in regions without the leakage-prone contact 31, the electrode groove is not formed at the leakage-prone contact 31, and then an interrupted first electrode 700 is formed on the first doped conductive layer 161 in such manners as deposition and electroplating.

As shown in Fig. 22, in some other embodiments, the first doped conductive layer 161 can be a doped polysilicon layer, the second doped conductive layer 162 can be a doped amorphous silicon layer or a doped microcrystalline silicon layer, in this case, the first tunneling layer 200 can be a tunneling oxide layer or an intrinsic amorphous silicon layer, and the second tunneling layer 400 can be a tunneling oxide layer or an intrinsic amorphous silicon layer.

As shown in Fig. 22, in such an embodiment, the entire non-illuminated side 12 is further covered with a conductive thin film 120, such as a TCO thin film, the conductive thin film 120 can be the outermost layer of the non-illuminated side 12 of the back contact solar cell 100, an insulating groove 1201 is formed in the conductive thin film 120 to separate the portion of the conductive thin film 120 corresponding to the first region from the portion of the conductive thin film 120 corresponding to the second region, the first electrode 700 can be respectively disposed on the conductive thin film 120 on the first region, and the second electrode 800 can be respectively disposed on the conductive thin film 120 on the second region, and in this case, the first electrode 700 and the second electrode 800 can be formed on the conductive thin film 120 by electroplating. As shown in Fig. 21, in such an embodiment, the portion of the leakage-prone contact 31 located outside the first recessed structure 173 is stacked on the first doped conductive layer 161 in the thickness direction to form a stacked structure, the leakage-prone contact 31 and the first doped conductive layer 161 are conducted in the thickness direction, and the insulating groove 1201 can be formed at the position of the stacked structure.

In some embodiments, the leakage-prone contact 31 can preferably completely cover all sidewall surfaces and the bottom surface of the first recessed structure 173, of course, the leakage-prone contact 31 can also only cover part of the sidewall surfaces and not cover the bottom surface, or only cover part of the sidewall surfaces and cover the entire bottom surface, or only cover part of the sidewall surfaces and part of regions of the bottom surface, or cover all sidewall surfaces but not cover the bottom surface, which is not specifically limited herein.

Referring to Fig. 21, in some embodiments, the first recessed structure 173 completely penetrates through the first doped conductive layer 161 in the thickness direction of the first doped conductive layer 161 (i.e., the thickness direction of the back contact solar cell 100), so that the silicon substrate 1 is exposed at the first recessed structure 173. The leakage-prone contact 31 covers the silicon substrate 1 exposed from the first recessed structure 173 and covers at least part of regions of the sidewall surfaces of the first recessed structure 173.

In this way, the first recessed structure 173 completely penetrates through the first doped conductive layer 161, the first recessed structure 173 is a through groove penetrating through the first doped conductive layer 161, the silicon substrate 1 is exposed at the first recessed structure 173, the leakage-prone contact 31 forms a leakage contact with the first doped conductive layer 161 on the sidewall surface of the first recessed structure 173, so as to improve the hot spot resistance, meanwhile the leakage-prone contact 31 is in contact with the silicon substrate 1 at the bottom of the first recessed structure 173, and when the second doped conductive layer 162 is an emitter doped layer of the back contact solar cell 100, the area of the emitter of the back contact solar cell 100 can be further increased by using this setting manner, thereby improving the efficiency of the back contact solar cell 100.

Specifically, in such an embodiment, the leakage-prone contact 31 only forms the leakage contact with the first doped conductive layer 161 on the sidewall surface of the first recessed structure 173, and the portion of the leakage-prone contact 31 located at the bottom of the first recessed structure 173 acts as the emitter.

Referring to Fig. 21, in some embodiments, the first recessed structure 173 completely penetrates through the first doped conductive layer 161 and forms a trench 125 in the silicon substrate 1, and a recess depth of the trench 125 on the silicon substrate 1 is 1 µm to 6 µm.

In this way, by the settings in which the first recessed structure 173 completely penetrates through the first doped conductive layer 161 and forms the trench 125 in the silicon substrate 1, the leakage-prone contact 31 does not form the leakage contact with the first doped conductive layer 161 at the bottom of the first recessed structure 173, but directly forms a contact with the silicon substrate 1, and when the second doped conductive layer 162 is an emitter, the area of the emitter can be increased, thereby improving the efficiency.

Specifically, the recess depth of the trench 125 on the silicon substrate 1 can be, for example, 1 µm, 1.5 µm, 2 µm, 2.5 µm, 3 µm, 3.5 µm, 4 µm, 4.5 µm, 5 µm, 5.5 µm, 6 µm, or any numerical value between 1 µm and 6 µm.

Further, in some embodiments, an internal expansion layer (not shown) is formed in the portion of the silicon substrate 1 corresponding to the first region 13, and the polarity of the internal expansion layer is the same as the polarity of the first doped conductive layer 161; and the first recessed structure 173 does not penetrate through the internal expansion layer, and the leakage-prone contact 31 is in leakage contact with the surface of the internal expansion layer facing away from the silicon substrate 1.

In this way, in addition to forming the leakage contact with the first doped conductive layer 161 at the sidewall surface of the first recessed structure 173, the leakage-prone contact 31 further forms a leakage contact with the internal expansion layer on the bottom surface of the first recessed structure 173, so that the leakage contact area can be increased, thereby further improving the hot spot resistance.

Of course, in some embodiments, the first recessed structure 173 can also penetrate the internal expansion layer, and the leakage-prone contact 31 is in leakage contact with the side surface of the internal expansion layer exposed to the first recessed structure 173. In this way, in addition to forming the leakage contact with the first doped conductive layer 161, the leakage-prone contact 31 further forms the leakage contact with the side surface of the internal expansion layer, thereby improving the hot spot resistance.

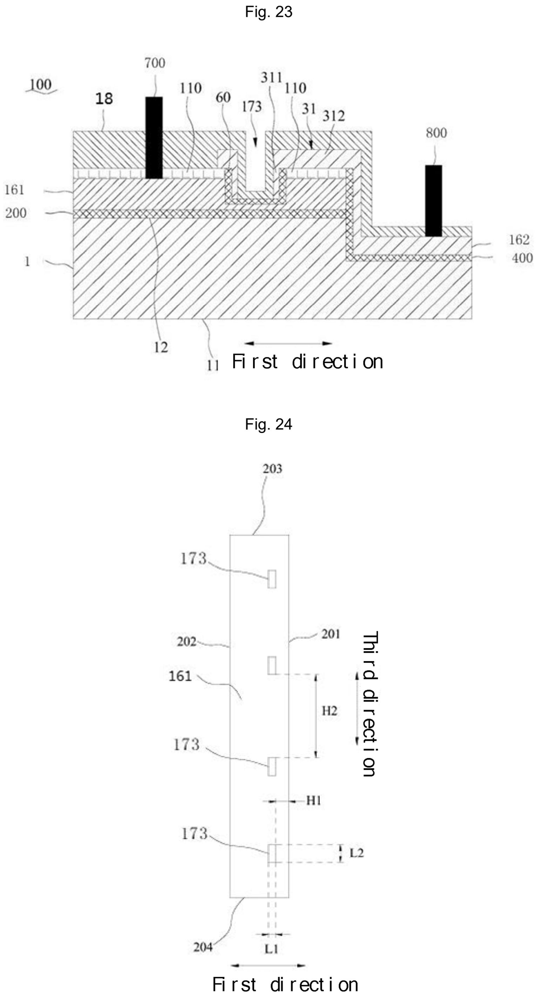

Referring to Fig. 23, in some embodiments, the first recessed structure 173 does not completely penetrate through the first doped conductive layer 161 in the thickness direction of the first doped conductive layer 161, and the leakage-prone contact 31 covers at least part of regions of the bottom surface of the first recessed structure 173 and at least part of regions of the sidewall surface of the first recessed structure 173.

In this way, the first recessed structure 173 is a blind slot that does not completely penetrate through the first doped conductive layer 161, and the leakage-prone contact 31 can form the leakage contact with the first doped conductive layer 161 on the bottom surface and the sidewall surface of the first recessed structure 173.

Further, in some embodiments, the first recessed structure 173 does not completely penetrate through the first doped conductive layer 161 in the thickness direction of the first doped conductive layer 161, and the recess depth of the first recessed structure 173 is 20 nm to 200 nm.

In this way, by reasonably controlling the recess depth of the first recessed structure 173, the leakage contact area formed by the leakage-prone contact 31 in the first recessed structure 173 can be controlled within a reasonable range, thereby avoiding an overlarge efficiency loss.

Specifically, in such an embodiment, the recess depth of the first recessed structure 173 can be, for example, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, or any numerical value between 20 nm and 200 nm, which is not specifically limited herein.

Referring to Fig. 21 and Fig. 24, in some embodiments, the first doped conductive layer 161 has a first side surface 201 and a second side surface 202, which are opposite to each other in the first direction, the first recessed structure 173 does not penetrate through the first side surface 201 and the second side surface 202 (as shown in Fig. 24), and the both sides of the first recessed structure 173 are provided with the first doped conductive layers 161 in the first direction.

In this way, the area of the first recessed structure 173 can be controlled within a reasonable range, thereby avoiding excessive efficiency losses.

Specifically, as shown in Fig. 24, in such an embodiment, the first doped conductive layer 161 has a third side surface 203 and a fourth side surface 204, which are opposite to each other in the third direction, the first recessed structure 173 can be located in an intermediate region of the first doped conductive layer 161, and the first recessed structure 173 is only provided with a notch facing away from the silicon substrate 1, that is, the first recessed structure 173 does not penetrate the third side surface 203 and the fourth side surface 204. Of course, in some embodiments, the first recessed structure 173 can also penetrate through at least one of the third side surface 203 and the fourth side surface 204 in the third direction.

In addition, in some embodiments, on a single first doped conductive layer 161, there can be a single or a plurality of first recessed structures 173, when there is a single first recessed structure 173, the first recessed structure 173 cannot penetrate through the first side surface 201 and the second side surface 202 and not penetrate through the third side surface 203 and the fourth side surface 204, can penetrate through the third side surface 203 but does not penetrate through the fourth side surface 204, and can penetrate through the third side surface 203 and the fourth side surface 204 at the same time (that is, the first recessed structure 173 continuously extends in the third direction to penetrate through the two ends of the first doped conductive layer 161 in the third direction).

When there are a plurality of first recessed structures 173, in some embodiments, all first recessed structures 173 cannot penetrate through the third side surface 203 and the fourth side surface 204. In some other embodiments, the first recessed structure 173 closest to the third side surface 203 can also penetrate through the third side surface 203, and the first recessed structure 173 closest to the fourth side surface 204 can also penetrate through the fourth side surface 204, which is not specifically limited herein.

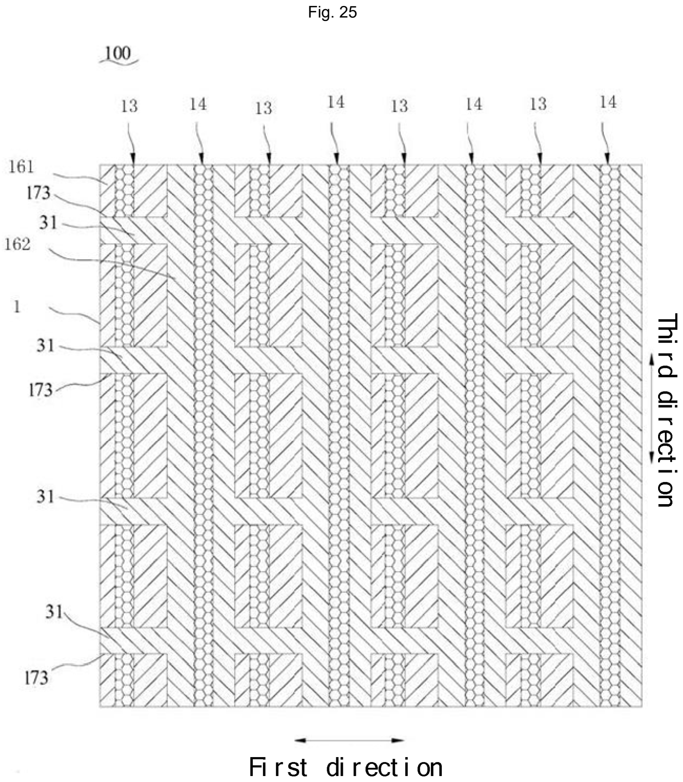

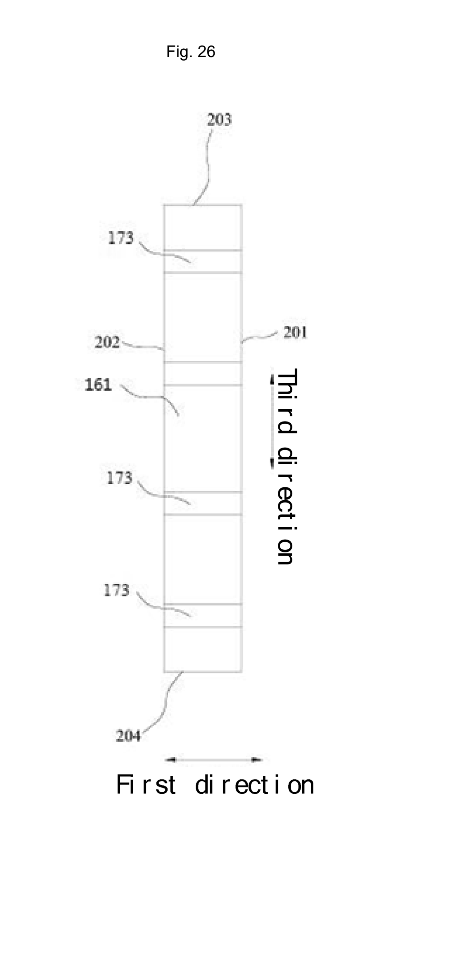

Of course, referring to Fig. 25 and Fig. 26, in some embodiments, the first recessed structure 173 can also penetrate through at least one of the first side surface 201 and the second side surface 202. For example, as shown in Fig. 25 and Fig. 26, in one example, the first recessed structure 173 can penetrate through the first side surface 201 and the second side surface 202 of the first doped conductive layer 161 in the first direction. In another example, and the first recessed structure 173 can also only penetrate through the first side surface 201 or only penetrate through the second side surface 202 in the first direction, which is not specifically limited herein.

Specifically, as shown in Fig. 25, in some embodiments, the first recessed structures 173 penetrating through the first side surface 201 and the second side surface 202 can be formed on all first doped conductive layers 161, and two adjacent second doped conductive layers 162 are connected by the leakage-prone contact 31 located in the first recessed structure 173, that is, the leakage-prone contact 31 traverses the first doped conductive layer 161 in the first recessed structure 173 in the first direction, so as to connect the two adjacent second doped conductive layers 162 together.

In such an embodiment, the first recessed structure 173 can penetrate through the first doped conductive layer 161 in the thickness direction, and in this case, the leakage-prone contact 31 is in leakage contact with the first doped conductive layer 161 at the sidewall surface of the first recessed structure 173. Of course, the first recessed structure 173 can also not penetrate through the first doped conductive layer 161 in the thickness direction, and in this case, the leakage-prone contact 31 is in leakage contact with the first doped conductive layer 161 at the sidewall surface and/or the bottom surface of the first recessed structure 173.

As shown in Fig. 25, when the first recessed structure 173 penetrates through the first side surface 201 and the second side surface 202 at the same time, the leakage-prone contact 31 can completely cover the bottom surface of the first recessed structure 173, and in this case, an interrupted electrode structure can be formed for the first electrode 700 in the above manner of forming the interrupted electrode grooves and performing deposition and electroplating.

Referring to Fig. 21 and Fig. 23, in some embodiments, the leakage-prone contact 31 includes a first portion 311 located in the first recessed structure 173, and a second portion 312 stacked on the surface of the first doped conductive layer 161 facing away from the silicon substrate 1; and the first portion 311 is in leakage contact with the first doped conductive layer 161, and an dielectric insulating layer 110 is disposed between the second portion 312 and the first doped conductive layer 161.

In this way, only the first portion 311 of the leakage-prone contact 31 that is located in the first recessed structure 173 forms the leakage contact with the first doped conductive layer 161, so that the leakage contact area of the back contact solar cell 100 can be controlled, thereby avoiding an overlarge efficiency loss caused by an overlarge leakage contact area.

Specifically, in such an embodiment, the second portion 312 covers a region other than the first recessed structure 173, the second portion 312 is insulated and isolated from the first doped conductive layer 161 by the dielectric insulating layer 110, and the leakage-prone contact 31 forms the leakage contact with the first doped conductive layer 161 only by the first portion 311. The dielectric insulating layer 110 can be a dielectric film layer having an insulating function, such as a silicon oxide film layer and a silicon nitride film layer.

Of course, it can be understood that in some embodiments, the second portion 312 can also form a leakage contact with the surface of the first doped conductive layer 161 facing away from the silicon substrate 1 on the premise of ensuring that the efficiency of the back contact solar cell is not greatly reduced, which is not specifically limited herein.

Still referring to Fig. 21 and Fig. 23, in some embodiments, the leakage-prone contact 31 extends along the side surface of the first doped conductive layer 161 to the surface of the first doped conductive layer 161 facing away from the silicon substrate 1 and into the first recessed structure 173, and the leakage-prone contact 31 also forms a leakage contact with the first doped conductive layer 161 at the side surface of the first doped conductive layer 161.

In this way, the leakage-prone contact 31 further forms the leakage contact with the first doped conductive layer 161 at the side surface of the first doped conductive layer 161, which can improve the leakage contact area, thereby further improving the hot spot resistance.

Specifically, as shown in Fig. 21 and Fig. 23, in such an embodiment, the leakage-prone contact 31 of the second doped conductive layer 162 located on one side of the first side surface 201 can extend along the first side surface 201 of the first doped conductive layer 161 to the surface of the first doped conductive layer 161 facing away from the silicon substrate 1, and then further extend into the first recessed structure 173, and the leakage-prone contact 31 forms a leakage contact with the first side surface 201.

Of course, in some embodiments, the leakage-prone contact 31 of the second doped conductive layer 162 located on one side of the second side surface 202 can extend along the second side surface 202 of the first doped conductive layer 161 to the surface of the first doped conductive layer 161 facing away from the silicon substrate 1, and then further extend into the first recessed structure 173, and the leakage-prone contact 31 also forms a leakage contact with the second side surface 202, which is not specifically limited herein.

Referring to Fig. 24, in some embodiments, in the first direction, there is a first predetermined distance H1 between the first recessed structure 173 and the side surface (i.e., one of the first side surface 201 or the second side surface 202 that is closest to the first recessed structure 173) of the first doped conductive layer 161, and the size of the first predetermined distance H1 can be 10 µm to 200 µm.

In this way, it can be avoided that the first electrode 700 cannot be disposed at the center due to the fact that the distance between the first electrode 700 and the first side surface 201 or the distance between the first electrode 700 the second side surface 202 is too large because of an overlarge distance between the first recessed structure 173 and the first side surface 201 or the second side surface 202 of the first doped conductive layer 161, thereby improving the collection efficiency of the first electrode 700, and it can also be avoided that the process difficulty is greatly increased due to the fact that the distance between the first recessed structure 173 and the first side surface 201 or the second side surface 202 of the first doped conductive layer 161 is too small.

Specifically, as shown in Fig. 24, in such an embodiment, the first recessed structure 173 cannot penetrate through the first side surface 201 and the second side surface 202, the first recessed structure 173 can be disposed close to the first side surface 201, in this case, the second doped conductive layer 162 close to the first side surface 201 is provided with the leakage-prone contact 31, the leakage-prone contact 31 extends into the first recessed structure 173, the first electrode 700 can be disposed between the first recessed structure 173 and the second side surface 202, the first electrode 700 can be of a continuous uninterrupted structure, and the first predetermined distance H1 is sent within the above reasonable range, so that it can be avoided that the collection efficiency of the first electrode 700 is greatly reduced due to the fact that the distance between the first electrode 700 and the first side surface 201 is too large.

In such an embodiment, the size of the first predetermined distance H1 can be, for example, 10 µm, 20 µm, 30 µm, 40 µm, 50 µm, 60 µm, 70 µm, 80 µm, 90 µm, 100 µm, 110 µm, 120 µm, 130 µm, 140 µm, 150 µm, 160 µm, 170 µm, 180 µm, 190 µm, 200 µm, or any numerical value between 10 µm and 200 µm.

Referring to Fig. 24, in some embodiments, in the first direction, the length L1 of the first recessed structure 173 is 10 µm to 80 µm.

In this way, by reasonably controlling the length of the first recessed structure 173 in the first direction, it can also be avoided that the collection efficiency is greatly reduced due to the fact that the first electrode 700 cannot be disposed at the center because of an overlarge width of the first recessed structure 173, that is, by setting the length of the first recessed structure 173 in the first direction within this reasonable range, the collection efficiency of the first electrode 700 can be improved.

Specifically, in such an embodiment, the length L1 of the first recessed structure 173 in the first direction can be, for example, 10 µm, 20 µm, 30 µm, 40 µm, 50 µm, 60 µm, 70 µm, 80 µm, or any numerical value between 10 µm and 80 µm.

Referring to Fig. 24, in some embodiments, in the third direction, the length L2 of the first recessed structure 173 is 10 µm to 500 µm.

In this way, by setting the length of the first recessed structure 173 in the third direction within this reasonable range, an overlarge efficiency loss caused by an overlarge leakage contact area in the single first recessed structure 173 can be avoided.

Specifically, in such an embodiment, the length L2 of the first recessed structure 173 in the third direction can be, for example, 10 µm, 20 µm, 30 µm, 40 µm, 50 µm, 60 µm, 70 µm, 80 µm, 90 µm, 100 µm, 110 µm, 120µm, 130 µm, 140 µm, 150 µm, 160 µm, 170 µm, 180 µm, 190 µm, 200 µm, 220 µm, 240 µm, 260 µm, 280 µm, 300 µm, 320 µm, 340 µm, 360 µm, 380 µm, 400 µm, 420 µm, 440 µm, 460 µm, 480 µm, 500 µm, or any numerical value between 10 µm and 500 µm.

In some embodiments, the ratio of the length L2 of the first recessed structure 173 in the third direction to the length L1 of the first recessed structure 173 in the first direction is greater than or equal to 2.

In this way, in order to improve the collection efficiency, when the groove width of the first recessed structure 173 is smaller, by setting the length of the first recessed structure 173 in the third direction to be greater, the leakage contact area can be improved to ensure the hot spot resistance.

Referring to Fig. 20, Fig. 24 and Fig. 25, in some embodiments, there are a plurality of first recessed structures 173 on a single first doped conductive layer 161, and the plurality of first recessed structures 173 are arranged at intervals in the third direction.

In this way, by disposing the plurality of isolated first recessed structures 173 on the first doped conductive layer 161, an overlarge efficiency loss caused by an overlarge leakage contact area on the single first doped conductive layer 161 can be avoided.

Referring to Fig. 24, in some embodiments, the first recessed structures 173 on the first doped conductive layer 161 can be arranged in one column in the third direction, which can simplify the process and improve the efficiency.

Of course, in some embodiments, in order to avoid excessive concentration of the first recessed structures 173, the first recessed structures 173 on the first doped conductive layer 161 can be arranged in at least two columns in the third direction.

Further, in some embodiments, in the third direction, the distance H2 between two adjacent first recessed structures 173 is 1 cm to 10 cm.

In this way, it is possible to avoid the situation in which the temperature is greatly increased due to the fact that the heat cannot be dissipated in time because of excessive concentration of leakage points resulting from an excessively small distance H2 between two adjacent first recessed structures 173.

Specifically, in such an embodiment, the distance H2 between two adjacent first recessed structures 173 can be, for example, 1 cm, 1.5 cm, 2 cm, 2.5 cm, 3 cm, 3.5 cm, 4 cm, 4.5 cm, 5 cm, 5.5 cm, 6 cm, 6.5 cm, 7 cm, 7.5 cm, 8 cm, 8.5 cm, 9 cm, 9.5 cm, 10 cm, or any numerical value between 1 cm and 10 cm.

Further, in such an embodiment, in the third direction, the distance H2 between two adjacent first recessed structures 173 is preferably greater than or equal to 2 cm and less than 4 cm.

In this way, through research and demonstrations by the inventors of the present disclosure, by setting the spacing within this preferred range, excessive concentration of heat can be maximally avoided when a greater number of first recessed structures 173 are provided, that is, the relationship between the heat spot resistance and excessive concentration of heat can be balanced to achieve an optimal matching effect.

Specifically, in such an embodiment, the distance H2 between two adjacent first recessed structures 173 can be preferably, for example, 2 cm, 2.2 cm, 2.4 cm, 2.6 cm, 2.8 cm, 3 cm, 3.1 cm, 3.2 cm, 3.3 cm, 3.4 cm, 3.5 cm, 3.6 cm, 3.7 cm, 3.9 cm, and 3.95 cm.

In some embodiments, regions in the first doped conductive layer 161 and the second doped conductive layer 162 that are not covered by the leakage-prone contact 31 are leakage-free regions, and regions in the first doped conductive layer 161 and the second doped conductive layer 162 other than the leakage-free regions are leakage-prone regions. In order to reduce the recombination of the leakage-free regions, within the same unit length, the number of the first recessed structures 173 in the leakage-free regions is greater than the number of the first recessed structures 173 in the leakage-prone regions.

In some embodiments, in the back contact solar cell 100, the distribution density of the first recessed structures 173 is 0.01 piece/cm² to 1.5 pieces/cm². In this way, by reasonably controlling the distribution density of the first recessed structures 173, excessively concentrated distribution of electric leakage points can be avoided.

In such an embodiment, the distribution density of the first recessed structures 173 refers to the ratio of the sum of the numbers of the first recessed structures 173 on the back contact solar cell 100 to the area of the non-illuminated side 12 of the back contact solar cell 100. Specifically, the distribution density of the first recessed structures 173 can be, for example, 0.01 piece/cm², 0.05 pieces/cm², 0.1 piece/cm², 0.2 pieces/cm², 0.3 pieces/cm², 0.4 pieces/cm², 0.5 pieces/cm², 0.6 pieces/cm², 0.7 pieces/cm², 0.8 pieces/cm², 0.9 pieces/cm², 1 piece/cm², 1.1 pieces/cm², 1.2 pieces/cm², 1.3 pieces/cm², 1.4 pieces/cm², 1.5 pieces/cm², or any numerical value between 0.01 piece/cm² to 1.5 pieces/cm².

In some embodiments, in a single first recessed structure 173, the leakage contact area between the leakage-prone contact 31 and the first doped conductive layer 161 is 1.2 µm² to 1500 µm2.

In this way, by controlling the leakage contact area in the single first recessed structure 173 within this reasonable range, it can be ensured that the efficiency loss is not too large while the hot spot resistance is improved.

Specifically, in such an embodiment, the leakage contact area between the leakage-prone contact 31 and the first doped conductive layer 161 can be, for example, 1.2 µm², 2 µm², 5 µm², 10 µm², 50 µm², 100 µm², 200 µm², 300 µm², 350 µm², 400 µm², 450 µm², 480 µm², 500 µm², 600 µm², 700 µm², 800 µm², 900 µm², 1000 µm², 1100 µm², 1200 µm², 1300 µm², 1400 µm², 1500µm², or any numerical value between 1.2 µm² to 1500 µm².

In some embodiments, in the back contact solar cell 100, the ratio of the sum of the leakage contact areas between all leakage-prone contacts 31 and the first doped conductive layers 161 to the area of the non-illuminated side of the back contact solar cell 100 (i.e., the area of the non-illuminated side 12 of the silicon substrate 10) is 4.5*10⁻⁸ to 1.5*10⁻⁵.

In this way, by setting the ratio of the leakage contact area to the non-illuminated side 12 within this reasonable range, it is possible to avoid the situation in which the efficiency of the back contact solar cell 100 is seriously affected by an overlarge ratio of the leakage contact area, that is, the efficiency of the back contact solar cell 100 can be ensured while the hot spot resistance is ensured.

Specifically, in such an embodiment, the ratio of the areas of the two can be, for example, 4.5*10⁻⁸, 5*10-⁸, 6*10-⁸, 7*10-⁸, 8*10-⁸, 9*10⁻⁸, 1*10⁻⁷, 1 * 10⁻⁶, 1*10⁻⁵, 1.5* 10⁻⁵, or any other numerical value between 4.5*10⁻⁸ to 1.5*10⁻⁵, which is not specifically limited herein.

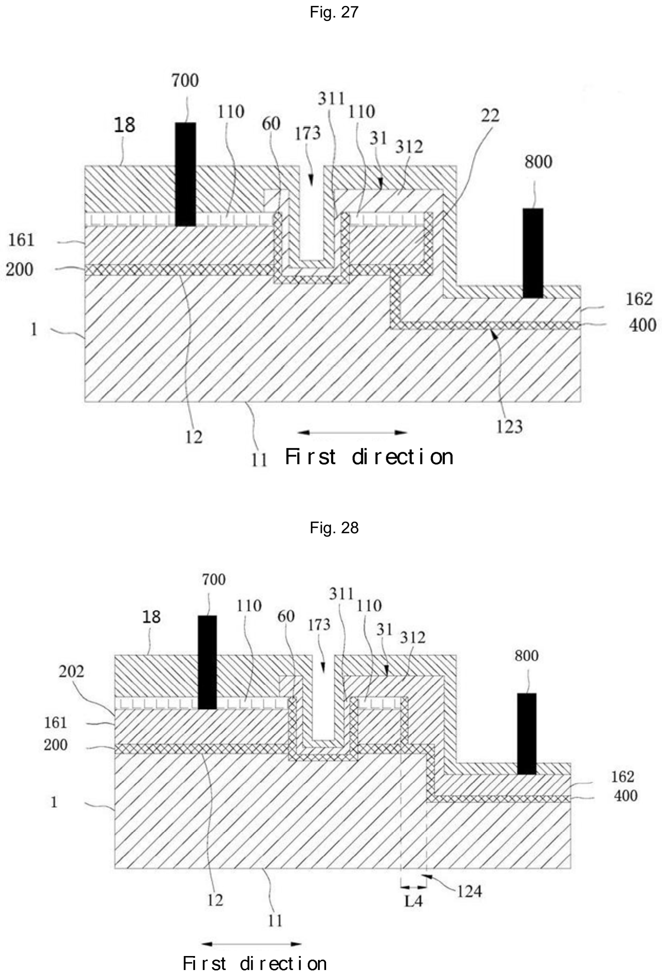

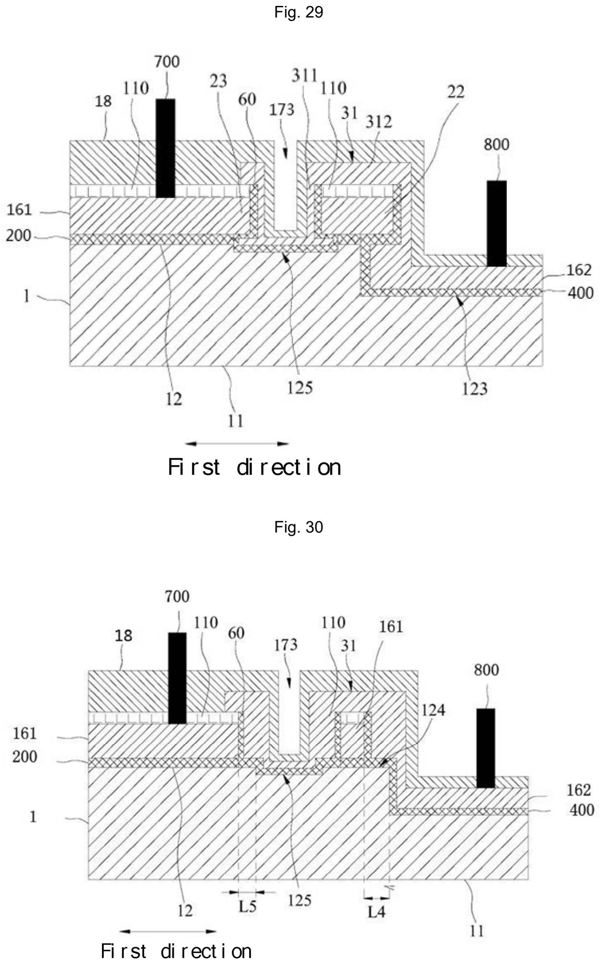

Referring to Fig. 27 and Fig. 29, in some embodiments, the second region 14 is a groove 123 formed in the silicon substrate 1, the first doped conductive layer 161 is provided with a first protruding portion 22 extending to the upper side of the groove 123, and the leakage-prone contact 31 extends along a sidewall surface of the groove 123 to surround the first protruding portion 22 and extends to cover the first doped conductive layer 161, and further extends into the first recessed structure 173.

In this way, the leakage-prone contact 31 and the first protruding portion 22 can also form a leakage contact, thereby improving the hot spot resistance.

Specifically, in such an embodiment, the first doped conductive layer 161 can be a P-type doped layer, the second doped conductive layer 162 can be an N-type doped layer, the P-type doped layer is provided with the first protruding portion 22, the leakage-prone contact 31 can only form a leakage contact with the surface of the first protruding portion 22 facing the groove 123, and can also form leakage contacts with the surface of the first protruding portion 22 facing the groove 123 and a sidewall surface of the first protruding portion 22 at the same time, which is not specifically limited herein.

Referring to Fig. 28, in some embodiments, the second region 14 is a groove 123 formed in the silicon substrate 1, the first doped conductive layer 161 does not completely cover the first region 13, so that the first region 13 has an exposed region 124, which is not covered by the first doped conductive layer 161, between the first doped conductive layer 161 and the groove 123, and the leakage-prone contact 31 extends to the exposed region 124 and covers the exposed region 124.

In this way, when the second doped conductive layer 162 is the emitter of the back contact solar cell 100, by disposing the exposed region 124, the area of the emitter can be increased, thereby improving the efficiency of the back contact solar cell 100, and meanwhile, by disposing the exposed region 124, the first doped conductive layer 161 is not exposed at the cross section of the groove 123, so that recombination can be reduced.

Specifically, in such an embodiment, the first doped conductive layer 161 is an N-type doped layer, and the second doped conductive layer 162 is a P-type doped layer.

Further, in such an embodiment, in the first direction, the length L4 of the exposed region 124 is 0.3 µm to 50 µm.

In this way, by setting the length of the exposed region 124 in the first direction within this reasonable range, greater recombination caused by an excessively small width can be avoided, and it can be also avoided that the overall efficiency of the cell is affected by excessively low collection efficiency of carriers due to an overlarge area of the first doped conductive layer 161 resulting from an overlarge length.

Specifically, in such an embodiment, the length L4 of the exposed region 124 can be, for example, 0.3 µm, 0.4 µm, 0.5 µm, 0.6 µm, 0.7 µm, 0.8 µm, 0.9 µm, 1 µm, 2 µm, 3 µm, 4 µm, 5 µm, 6 µm, 7 µm, 8 µm, 9 µm, 10 µm, 15 µm, 20 µm, 25 µm, 30 µm, 40 µm, 45 µm, 50 µm, or any numerical value between 0.3 µm to 50 µm, which is not specifically limited herein.

In some embodiments, the length L4 of the exposed region 124 in the first direction can preferably be 1 µm to 20 µm.

Referring to Fig. 29, in some embodiments, the first recessed structure 173 completely penetrates through the first doped conductive layer 161 and forms a trench 125 in the silicon substrate 1, the first doped conductive layers 161 located on both sides of the trench 125 are provided with second protruding portions 23 extending to the upper side of the trench 125, and the leakage-prone contact 31 surrounds at least one second protruding portion 23 and extends into the first recessed structure 173.

In this way, the leakage-prone contact 31 and the second protruding portion 23 can also form a leakage contact, thereby improving the hot spot resistance.

Specifically, in such an embodiment, the first doped conductive layer 161 can be a P-type doped layer, the second doped conductive layer 162 can be an N-type doped layer, the P-type doped layer is provided with the second protruding portion 23, and the leakage-prone contact 31 can only form a leakage contact with the surface of the second protruding portion 23 facing the groove 123, and can also form leakage contacts with the surface of the second protruding portion 23 facing the groove 123 and a sidewall surface of the second protruding portion 23 at the same time, which is not specifically limited herein.

Referring to Fig. 30, in some embodiments, the first recessed structure 173 completely penetrates through the first doped conductive layer 161 and forms a trench 125 in the silicon substrate 1, and there are second present distances L5 between the first doped conductive layers 161 located on both sides of the trench 125 and an edge of the trench 125.

In this way, by setting the second predetermined distance L5, the first doped conductive layer 161 is not exposed at the cross section of the trench 125, so that recombination can be reduced.

Specifically, in such an embodiment, the first doped conductive layer 161 is an N-type doped layer, and the second doped conductive layer 162 is a P-type doped layer.

Further, in such an embodiment, the size of the second predetermined distance L5 can be 0.3 µm to 50 µm.

In this way, by setting the size of the second predetermined distance L5 within this reasonable range, greater recombination caused by an excessively small second predetermined distance L5 can be avoided, and it can be also avoided that the overall efficiency of the cell is affected by excessively low collection efficiency of carriers due to an overlarge area of the first doped conductive layer 161 resulting from an overlarge length.

Specifically, in such an embodiment, the size of the second predetermined distance L5 can be, for example, 0.3 µm, 0.4 µm, 0.5 µm, 0.6 µm, 0.7 µm, 0.8 µm, 0.9 µm, 1 µm, 2 µm, 3 µm, 4 µm, 5 µm, 6 µm, 7 µm, 8 µm, 9 µm, 10 µm, 15 µm, 20 µm, 25 µm, 30 µm, 40 µm, 45 µm, 50 µm, or any numerical value between 0.3 µm and 50 µm, which is not specifically limited herein.

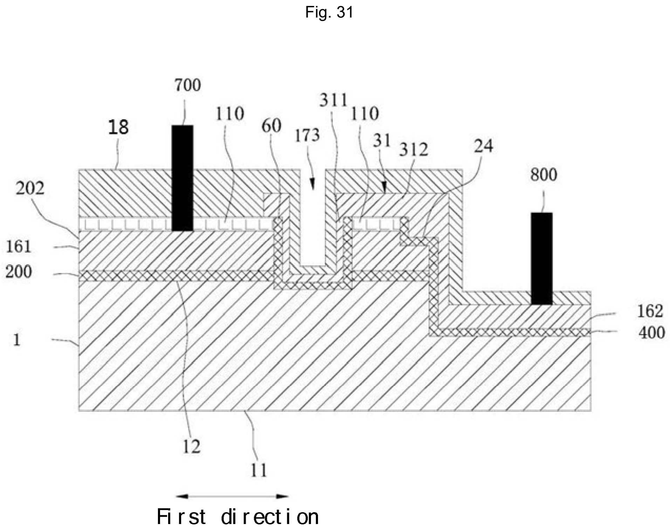

Referring to Fig. 31, in some embodiments, the second region 14 is a groove 123 formed in the silicon substrate 1, the first doped conductive layer 161 forms a step structure 24 at an edge of the side of the first doped conductive layer 161 facing the groove 123, the leakage-prone contact 31 covers a side surface of the first doped conductive layer 161 and the step structure 24, and the leakage-prone contact 31 is in leakage contact with the first doped conductive layer 161 at the step structure 24.

In this way, by disposing the step structure 24, the leakage-prone contact 31 can form a leakage contact with the first doped conductive layer 161 at the step structure 24, so that the electrode of the leakage contact can be improved, thereby improving the hot spot formation resistance of the back contact solar cell 100.

Specifically, as shown in Fig. 31, the first doped conductive layer 161 is provided with a step surface at the edge of the side of the first doped conductive layer 161 facing the groove 123, and the leakage-prone contact 31 covers the step surface and connects the step surface with a connection surface on an outermost side surface of the first doped conductive layer 161 facing away from the silicon substrate 1 and is in leakage contact with the first doped conductive layer 161 by means of the step surface and the connection surface.

The above description are only preferred embodiments of the present disclosure and are not intended to limit the present disclosure, and any modifications, equivalent replacements, improvements, and the like, made within the spirit and principles of the present disclosure, shall fall within the protection scope of the present disclosure.

## Claims

1. A back contact solar cell, comprising first regions, second regions and isolation regions, which are disposed on a non-illuminated side of a silicon substrate, wherein the first region and the second region are alternately disposed, the isolation region is located between the first region and the second region, the first region comprises a first doped conductive layer, the second region comprises a second doped conductive layer, and the first doped conductive layer and the second doped conductive layer have opposite doping types; and a side of the first region close to the isolation region is provided with a recessed structure, when the silicon substrate is an N-type silicon substrate, the first region is a P-type doped region, the second region is an N-type doped region, a side of the P-type doped region close to the isolation region is provided with n1 recessed structures, a side of the N-type doped region close to the isolation region is provided with n2 recessed structures, and n1>n2.

2. The back contact solar cell according to claim 1, wherein the side of the first region close to the isolation region is provided with discontinuous recessed structures; and/or a side of the second region close to the isolation region is provided with recessed structures.

3. The back contact solar cell according to claim 2, wherein the side of the second region close to the isolation region is provided with discontinuous recessed structures.

4. The back contact solar cell according to any of claims 1 to 3, wherein the recessed structure comprises a first unit region and a first recessed structure, the first unit region is disposed around the first recessed structure, and the first recessed structure comprises a pit and a protrusion disposed in the pit; or the first region comprises an extension portion extending and protruding to an upper side of the isolation region, the recessed structure comprises a second unit region and a second recessed structure, the second unit region is disposed around the second recessed structure, the extension portion is provided with the second recessed structure, and the second recessed structure is a blind hole or a punch hole.

5. The back contact solar cell according to claim 4, wherein,
a height of the protrusion is less than or equal to a depth of the pit; or
a shape of the protrusion comprises a pyramid shape and/or a frustum shape; or the silicon substrate has an illuminated side disposed opposite to the non-illuminated side, the protrusion comprises the silicon substrate and a passivation layer in a direction in which the illuminated side faces the non-illuminated side, and a sidewall of the pit comprises the passivation layer.

6. The back contact solar cell according to claim 4, wherein,
a width of a bottom of the protrusion is 0.1 µm to 1.5 µm, and the height of the protrusion is 0.01 µm to 10 µm; or
a width of an opening of the pit is 0.1 µm to 2 µm, and the depth of the pit is 0.01 µm to 10 µm.

7. The back contact solar cell according to claim 4, wherein the passivation layer of the back contact solar cell surrounds the extension portion, and the second recessed structure penetrates through the extension portion and the passivation layer; or a width of the second recessed structure is 0.1 µm to 1.5 µm.

8. The back contact solar cell according to claim 2, wherein a plurality of recessed structures form an isolation transition region, and a width of the isolation transition region is 5 µm to 30 µm.

9. The back contact solar cell according to claim 8, wherein the width of the isolation transition region is 10 µm to 15 µm.

10. The back contact solar cell according to claim 4, wherein a tunneling layer of the back contact solar cell comprises a first tunneling layer, the first tunneling layer is disposed between the first conductive doped layer and the silicon substrate of the first region, and the first doped conductive layer, the first tunneling layer and an edge of the silicon substrate in the first region all extend towards a center of an opening of the isolation region to form the extension portion, or only the first doped conductive layer extends towards the center of the opening of the isolation region to form the extension portion;
and/or, the tunneling layer of the back contact solar cell further comprises a second tunneling layer, the second tunneling layer is disposed between the second doped conductive layer and the silicon substrate of the second region; or the passivation layer of the back contact solar cell covers the first doped conductive layer, the second doped conductive layer and the isolation region, the back contact solar cell further comprises a first electrode and a second electrode, the first electrode penetrates through the passivation layer to be connected with the first doped conductive layer, and the second electrode penetrates through the passivation layer to be connected with the second doped conductive layer.

11. The back contact solar cell according to claim 10, wherein a diameter of the second recessed structure is 1.5 µm to 5 µm; or a length of the extension portion is 0.1 µm to 40 µm.

12. The back contact solar cell according to claim 1, wherein the side of the first region close to the isolation region comprises a first target region, a length of the first target region in an extension direction of the isolation region is greater than 50 µm, and the first target region does not comprise the recessed structure; and the side of the second region close to the isolation region comprises a second target region, a length of the second target region in the extension direction of the isolation region is greater than 50 µm, and the second target region does not comprise the recessed structure.

13. A back contact solar cell, comprising: a silicon substrate, wherein the silicon substrate has an illuminated side and a non-illuminated side opposite to each other, the non-illuminated side comprises first regions and second regions, and the first region and the second region are alternately arranged in a first direction, the first regions and the second regions all extend in a third direction, and the third direction intersects with the first direction;
several first doped conductive layers, wherein the first doped conductive layers are disposed on the first regions and cover at least part of the first regions, each first region is provided with the first doped conductive layer, and first recessed structures are formed on at least part of the first doped conductive layers; and
several second doped conductive layers, wherein the second doped conductive layers are disposed on the second regions and cover at least part of the second regions, each second region is provided with the second doped conductive layer, at least part of the second doped conductive layers are provided with leakage-prone contacts extending to the first doped conductive layers, and a part of the leakage-prone contacts extend into the first recessed structures, and the leakage-prone contacts are in leakage contact with the first doped conductive layers at least in the first recessed structures.

14. The back contact solar cell according to claim 13, wherein the leakage-prone contact comprises a first portion located in the first recessed structure, and a second portion stacked on a surface of the first doped conductive layer facing away from the silicon substrate, the first portion is in leakage contact with the first doped conductive layer, an dielectric insulating layer is disposed between the second portion and the first doped conductive layer, or the second portion is in leakage contact with a surface of the first doped conductive layer facing away from the silicon substrate; or
in the first direction, the leakage-prone contact extends along a side surface of the first doped conductive layer to the surface of the first doped conductive layer facing away from the silicon substrate and into the first recessed structure, and the leakage-prone contact also forms a leakage contact with the first doped conductive layer at the side surface of the first doped conductive layer; or
in the first direction, there is a first predetermined distance between the first recessed structure and the side surface of the first doped conductive layer, and a size of the first predetermined distance is 10 µm to 200 µm; or
in the first direction, a length of the first recessed structure is 10 µm to 80 µm, and/or in the third direction, the length of the first recessed structure is less than 10 µm to 500 µm.

15. The back contact solar cell according to claim 14, wherein a ratio of the length of the first recessed structure in the third direction to the length of the first recessed structure in the first direction is greater than or equal to 2.

16. The back contact solar cell according to claim 13, wherein,
the first doped conductive layer has a first side surface and a second side surface opposite to each other in the first direction, the first recessed structure does not penetrate through the first side surface and the second side surface, and both sides of the first recessed structure are provided with the first doped conductive layers in the first direction; or
the first doped conductive layer has the first side surface and the second side surface opposite to each other in the first direction, and the first recessed structure penetrates through at least one of the first side surface and the second side surface; or
the first recessed structure completely penetrates through the first doped conductive layer in a thickness direction of the first doped conductive layer, so that the silicon substrate is exposed at the first recessed structure, and the leakage-prone contact covers the silicon substrate exposed from the first recessed structure, and covers at least part of regions of a sidewall surface of the first recessed structure; or
the first recessed structure does not completely penetrate through the first doped conductive layer in the thickness direction of the first doped conductive layer, and the leakage-prone contact covers at least part of regions of a bottom surface of the first recessed structure and at least part of regions of the sidewall surface of the first recessed structure; or
the first recessed structure completely penetrates through the first doped conductive layer in the thickness direction of the first doped conductive layer and forms a trench in the silicon substrate, and a recess depth of the trench in the thickness direction of the silicon substrate is 1µm to 6µm; or
the first recessed structure completely penetrates through the first doped conductive layer in the thickness direction of the first doped conductive layer and forms a trench in the silicon substrate, the first doped conductive layers located on both sides of the trench are provided with second protruding portions extending to an upper side of the trench, and the leakage-prone contact surrounds at least one of the second protruding portions and extends into the first recessed structure; or
the first recessed structure completely penetrates through the first doped conductive layer in the thickness direction of the first doped conductive layer and forms a trench in the silicon substrate, and there is a second predetermined distance between the first doped conductive layers located on the both sides of the trench and an edge of the trench in the first direction.

17. The back contact solar cell according to claim 16, wherein an internal expansion layer is formed in a portion of the silicon substrate corresponding to the first region, and a polarity of the internal expansion layer is a same as a doping type of the first doped conductive layer;
the first recessed structure does not penetrate through the internal expansion layer, and the leakage-prone contact is in leakage contact with a surface of the internal expansion layer facing away from the silicon substrate; or
the first recessed structure penetrates through the internal expansion layer, and the leakage-prone contact is in leakage contact with a side surface of the internal expansion layer that is exposed at the first recessed structure.

18. The back contact solar cell according to claim 13, wherein the second region is a groove formed in the silicon substrate, the first doped conductive layer is provided with a first protruding portion extending to an upper side of the groove, and the leakage-prone contact extends along a sidewall surface of the groove to surround the first protruding portion and extends onto the first doped conductive layer, and extends into the first recessed structure; or
the second region is the groove formed in the silicon substrate, the first doped conductive layer does not completely cover the first region, so that the first region has an exposed region, which is not covered by the first doped conductive layer, between the first doped conductive layer and the groove, and the leakage-prone contact extends to the exposed region and covers the exposed region; or
at an edge of a side of the first doped conductive layer facing the groove, the first doped conductive layer is formed with a step structure, the leakage-prone contact covers the step structure, and the leakage-prone contact is in leakage contact with the first doped conductive layer at the step structure.

19. The back contact solar cell according to claim 13, wherein,
a dielectric layer is disposed on a region in the first recessed structure that is covered by the leakage-prone contact, the leakage-prone contact covers the dielectric layer, and the leakage-prone contact is in leakage contact with the first doped conductive layer in the first recessed structure by the dielectric layer.

20. The back contact solar cell according to claim 16, wherein a size of the second predetermined distance is 0.3 µm to 50 µm.

21. The back contact solar cell according to claim 13, wherein the first recessed structure does not completely penetrate through the first doped conductive layer in the thickness direction of the first doped conductive layer, and a recess depth of the first recessed structure is 20 nm to 200 nm; or on a single first doped conductive layer, there are a plurality of first recessed structures, and the plurality of first recessed structures are arranged at intervals in the third direction.

22. The back contact solar cell according to claim 13, wherein in the third direction, a distance between two adjacent first recessed structures is 1 cm to 10 cm; or the plurality of first recessed structures are arranged in at least two columns in the third direction.

23. The back contact solar cell according to claim 13, wherein in the back contact solar cell, a distribution density of the first recessed structures is 0.01 piece/cm² to 1.5 pieces/cm²; or in a single first recessed structure, a leakage contact area between the leakage-prone contact and the first doped conductive layer is 1.2 µm² to 1500 µm²; or in the back contact solar cell, a ratio of the sum of leakage contact areas of all leakage-prone contacts and the first doped conductive layers to the area of the back surface of the back contact solar cell is 4.5*10⁻⁸ to 1.5*10⁻⁵.

24. The back contact solar cell according to claim 13, wherein regions in the first doped conductive layer and the second doped conductive layer that are not covered by the leakage-prone contacts are leakage-free regions, and regions in the first doped conductive layer and the second doped conductive layer other than the leakage-free regions are leakage-prone regions; and
within a same unit length, a number of the first recessed structures in the leakage-free regions is greater than a number of the first recessed structures in the leakage-prone regions.

25. A photovoltaic module, comprising the back contact solar cell according to any of claims 1 to 24.

26. A photovoltaic system, comprising the photovoltaic module according to claim 25.
